(19) Europäisches Patentamt
European Patent Office
Office européen des brevets

(11) EP 4 541 867 A1

(12) EUROPEAN PATENT APPLICATION
published in accordance with Art. 153(4) EPC

(43) Date of publication:
**23.04.2025 Bulletin 2025/17**

(21) Application number: **23824002.2**

(22) Date of filing: **16.06.2023**

(51) International Patent Classification (IPC):
***C09K 5/14*** *(2006.01)* ***C08L 83/04*** *(2006.01)*
***C08L 83/05*** *(2006.01)* ***C08L 83/07*** *(2006.01)*

(52) Cooperative Patent Classification (CPC):
**C08L 83/04; C09K 5/14**

(86) International application number:
**PCT/JP2023/022402**

(87) International publication number:
**WO 2023/243712 (21.12.2023 Gazette 2023/51)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **17.06.2022 JP 2022098435**
**31.08.2022 JP 2022138189**

(71) Applicants:
- **SEKISUI CHEMICAL CO., LTD.**
**Osaka-shi**
**Osaka**
**530-8565 (JP)**
- **Sekisui Polymatech Co., Ltd.**
**Saitama-city, Saitama 338-0837 (JP)**

(72) Inventors:
- **IWAMOTO, Tatsuya**
**Mishima-gun, Osaka 618-0021 (JP)**
- **SUDA, Hiromi**
**Saitama-city, Saitama 338-0837 (JP)**

(74) Representative: **Ter Meer Steinmeister & Partner Patentanwälte mbB**
**Nymphenburger Straße 4**
**80335 München (DE)**

(54) **THERMALLY CONDUCTIVE COMPOSITION AND THERMALLY CONDUCTIVE MEMBER**

(57) A thermally conductive composition comprising: (A) an organopolysiloxane having two or more alkenyl groups; (B) an organo-hydrogen polysiloxane having two hydrosilyl groups; (C) an organo-hydrogen polysiloxane having three or more hydrosilyl groups; (D) an organopolysiloxane having one alkenyl or methacryloyl group; (E) a thermally conductive filler; and (F) a platinum group metal-based curing catalyst, wherein the ratio of a Raman intensity p1 at 2160 $cm^{-1}$ and a Raman intensity p2 at 2130 $cm^{-1}$ in a Raman spectroscopy spectrum, p2/p1, is larger than 3.00 and a type E hardness E2 after the composition is left to stand at 25°C for 24 hours and further at 150°C for 250 hours is less than 70.



Processed by Luminess, 75001 PARIS (FR)

## Description

### Technical Field

The present invention relates to a thermally conductive composition and a thermally conductive member.

### Background Art

Curable liquid types of thermally conductive compositions are widely known, and for example, are used as thermally conductive members, such as heat-dissipating gap fillers for conducting heat generated from a heating element to a heat-dissipating element, which are cured products formed by filling a curable liquid thermally conductive composition into gaps between a heating element and a heat-dissipating element, and then curing the composition. Traditionally, as such thermally conductive compositions, silicone thermally conductive compositions containing organopolysiloxane and a thermally conductive filler are widely used.

In recent market circumstances where the production quantity of electric vehicles is steadily growing, electrification for the purpose of enhancing energy efficiency and improve safety has been progressed. Regarding to in-vehicle parts for electrification, needs for automatic packaging are increasing, and there is an increasing demand for a liquid heat-dissipating gap filler usable in portions having complex shapes.

In recent vehicles, energy efficiency is one of important matters for differentiation, and it is demanded that the vehicle body weight is reduced as much as possible. The in-vehicle parts for electrification are no exception in this respect, and development for a reduction in weight and size has been progressed. However, a reduction in sizes of in-vehicle parts for electrification results in an increase in heat quantity generated per unit volume, that is, heat generation density. For this reason, the heat-dissipating gap filler should have reliability such that it can be used for a long time without degradation in performance such as thermal conductivity.

Traditional thermally conductive compositions have been examined for reliability in various ways. For example, Patent Literature 1 discloses a thermally conductive silicone composition comprising (A) an organopolysiloxane having at least two alkenyl groups in one molecule, (B) a hydrolyzable dimethylpolysiloxane having tri-functionality at one end, (C) a thermally conductive filler, (D) an organo-hydrogen polysiloxane terminated with a hydrosilyl group, (E) an organo-hydrogen polysiloxane having at least two hydrosilyl groups in one molecule, and (F) a platinum catalyst.

According to Patent Literature 1, by controlling the proportions of hydrosilyl groups and alkenyl groups in the components (A), (D), and (E) within predetermined ranges, occurrence of pumping out and/or peel-off during heating-cooling cycles for actual operation can be suppressed, and an increase in heat resistance can thus be suppressed. However, it is assumed in Patent Literature 1 that the heat generating electronic parts such as IC packages have a surface temperature of about 120°C, while the reliability in temperatures higher than that is not mentioned.

### Citation List

#### Patent Literature

PTL 1: JP 6079792 A

### Summary of Invention

#### Technical Problem

By the way, to improve the comfort of passenger cabins in recent vehicles, a larger cabin space is required. In examination of the layout of vehicle parts, large and heavy essential parts such as engines and motors often occupy higher priority, and relatively small and light-weight parts such as electrical component have to be disposed in the remaining spaces. As a result, some of the electrical component may be exposed to a high temperature environment at 150°C or higher inside the engine room or near the motor, and accordingly, the heat-dissipating gap filler may also be used under such a high temperature in some cases. However, when the heat-dissipating gap fillers formed of a traditional thermally conductive silicone thermally conductive composition are used under a high temperature environment at 150°C or more for a long time, the flexibility is reduced, causing peel-off from the heating element or the heat-dissipating element. Thus, it is difficult to suppress an increase in heat resistance.

For traditional thermally conductive compositions including a silicone resin containing an organopolysiloxane having an alkenyl group or an organo-hydrogen polysiloxane having a hydrosilyl group as the main components, it is also considered that, to increase the flexibility, the density of cross-linking points is reduced by increasing the lengths of chains between cross-linking points and thus reducing the functional group concentration. However, if the lengths of chains

between cross-linking points are increased, the silicone resin has an increased molecular weight and thus an increased viscosity, which obstructs filling of the resulting thermally conductive filler in a large amount.

The present invention has been made in consideration of such problems, and an object of the present invention is to provide a thermally conductive composition which can be formed into a thermally conductive member which is less likely to peel off from a heating element and/or a heat-dissipating element and thus less likely to cause an increase in heat resistance even under a use environment at 150°C or more.

Solution to Problem

As a result of extensive research, the present inventors have found that the above problems can be solved by a thermally conductive composition comprising specific components (A) to (F) wherein the concentrations of hydrosilyl groups in components (B) and (C) are controlled within predetermined ranges, or Raman intensities p1 and p2 derived from a hydrosilyl group in a Raman spectroscopy spectrum are controlled to satisfy a predetermined relation, and the type E hardness (E2) after the composition is left to stand at 25°C for 24 hours and further at 150°C for 250 hours is controlled to a predetermined value or less, and has completed the present invention below. Specifically, the present invention provides [1] to [23] below.

[1] A thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and
(F) a platinum group metal-based curing catalyst,

the Raman intensity p1 at 2160 $cm^{-1}$ and the Raman intensity p2 at 2130 $cm^{-1}$ in a Raman spectroscopy spectrum satisfying the relation represented by Expression (1-1) below, and
a type E hardness E2 after the composition is left to stand at 25°C for 24 hours and further at 150°C for 250 hours satisfying Expression (2) below:

$$p2/p1>3.00 \quad ...(1\text{-}1)$$

$$E2<70 \quad ...(2).$$

[2] A thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and
(F) a platinum group metal-based curing catalyst,

the components (B) and (C) being contained to satisfy the relation represented by Expression (1-2) below, and a type E hardness E2 after the composition is left to stand at 25°C for 24 hours and further at 150°C for 250 hours satisfying Expression (2) below:

$$b/(b+c)>0.45 \quad ...(1\text{-}2)$$

(In Expression (1-2), b represents the concentration of the hydrosilyl group contained in the component (B), and c represents the concentration of the hydrosilyl group contained in the component (C).)

$$E2<70 \quad ...(2).$$

[3] A thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and
(F) a platinum group metal-based curing catalyst,

the composition being formed of a combination of: a first agent containing at least one of the components (A) and (D); and the component (F) but not containing the component (B) and the component (C); and a second agent containing the component (B) and the component (C) but not containing the component (F),

the Raman intensity p1 at 2160 $cm^{-1}$ and the Raman intensity p2 at 2130 $cm^{-1}$ in a Raman spectroscopy spectrum satisfying the relation represented by Expression (1-1) below, and
a type E hardness E2 after the first agent and the second agent are mixed, and then are left to stand at 25°C for 24 hours and further at 150°C for 250 hours satisfying Expression (2) below:

$$p2/p1>3.00 \quad ...(1\text{-}1)$$

$$E2<70 \quad ...(2).$$

[4] A thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and
(F) a platinum group metal-based curing catalyst,

the composition being formed of a combination of: a first agent containing at least one of the components (A) and (D); and the component (F) but not containing the component (B) and the component (C); and a second agent containing the component (B) and the component (C) but not containing the component (F),

the components (B) and (C) being contained to satisfy the relation represented by Expression (1-2) below, and
a type E hardness E2 after the first agent and the second agent are mixed, and then are left to stand at 25°C for 24 hours and further at 150°C for 250 hours satisfying Expression (2) below:

$$b/(b+c)>0.45 \quad ...(1\text{-}2)$$

(In Expression (1-2), b represents the concentration of the hydrosilyl group contained in the component (B), and c represents the concentration of the hydrosilyl group contained in the component (C).)

$$E2<70 \quad ...(2).$$

[5] A thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and
(F) a platinum group metal-based curing catalyst,

the Raman intensity p1 at 2160 $cm^{-1}$ and the Raman intensity p2 at 2130 $cm^{-1}$ in a Raman spectroscopy spectrum satisfying the relation represented by Expression (1-1) below or the components (B) and (C) being contained to satisfy the relation represented by Expression (1-2) below, and

a type E hardness E2 after the composition is left to stand at 25°C for 24 hours and further at 150°C for 250 hours satisfying Expression (2) below:

$$p2/p1>3.00 \quad ...(1\text{-}1)$$

$$b/(b+c)>0.45 \quad ...(1\text{-}2)$$

(In Expression (1-2), b represents the concentration of the hydrosilyl group contained in the component (B), and c represents the concentration of the hydrosilyl group contained in the component (C).)

$$E2<70 \qquad ...(2).$$

[6] The thermally conductive composition according to [5], wherein the composition is formed of a combination of:

a first agent containing at least one of the components (A) and (D); and the component (F) but not containing the component (B) and the component (C), and
a second agent containing the component (B) and the component (C) but not containing the component (F).

[7] The thermally conductive composition according to any one of [1] to [6], further comprising: (G) an organopolysiloxane having no addition reactive group.
[8] The thermally conductive composition according to [7], wherein the component (G) contains: (G-2) an organopolysiloxane having at least one alkoxy group.
[9] The thermally conductive composition according to any one of [1] to [8], wherein a type E hardness E1 after the composition is left to stand at 25°C for 24 hours and the type E hardness E2 satisfy the relation represented by Expression (3) below:

$$1.4\leq E2/E1\leq 3.5 \qquad ...(3).$$

[10] The thermally conductive composition according to any one of [1] to [9], wherein the component (D) is an organopolysiloxane having one methacryloyl group.
[11] The thermally conductive composition according to any one of [1] to [10], wherein the total content of the alkenyl group and the methacryloyl group is 5.0 μmol/g or less.
[12] The thermally conductive composition according to any one of [1] to [11], wherein the content of the hydrosilyl group, H, and the total content of the alkenyl group and the methacryloyl group, Vi, satisfy the relation represented by Expression (4) below:

$$0.85\leq H/Vi\leq 1.1 \quad ....(4).$$

[13] A thermally conductive member which is a cured product of the thermally conductive composition according to any one of [1] to [12].
[14] A first agent usable as a thermally conductive composition by mixing with a second agent, the thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and
(F) a platinum group metal-based curing catalyst,

the first agent containing at least one of the components (A) and (D); and the component (F) but not containing the component (B) and the component (C),
the Raman intensity p1 at 2160 $cm^{-1}$ and the Raman intensity p2 at 2130 $cm^{-1}$ in a Raman spectroscopy spectrum satisfying the relation represented by Expression (1-1) below in a case where the first agent is combined with the second agent, and

a type E hardness E2 after the first agent and the second agent are mixed, and then are left to stand at 25°C for 24 hours and further at 150°C for 250 hours satisfying Expression (2) below:

$$p2/p1>3.00 \quad ...(1-1)$$

$$E2<70 \quad ...(2).$$

[15] A second agent usable as a thermally conductive composition by mixing with a first agent, the thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and
(F) a platinum group metal-based curing catalyst,

the second agent containing the component (B) and the component (C) but not containing the component (F), the Raman intensity p1 at 2160 $cm^{-1}$ and the Raman intensity p2 at 2130 $cm^{-1}$ in a Raman spectroscopy spectrum satisfying in a case where the second agent is combined with the first agent, the relation represented by Expression (1-1) below, and
a type E hardness E2 after the first agent and the second agent are mixed, and then are left to stand at 25°C for 24 hours and further at 150°C for 250 hours satisfying Expression (2) below:

$$p2/p1>3.00 \quad ...(1-1)$$

$$E2<70 \quad ...(2).$$

[16] A first agent usable as a thermally conductive composition by mixing with a second agent, the thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and
(F) a platinum group metal-based curing catalyst,

the first agent containing at least one of the components (A) and (D); and the component (F) but not containing the component (B) and the component (C),
the thermally conductive composition containing the components (B) and (C) to satisfy the relation represented by Expression (1-2) below, and
a type E hardness E2 after the first agent and the second agent are mixed, and then are left to stand at 25°C for 24 hours and further at 150°C for 250 hours satisfying Expression (2) below:

$$b/(b+c)>0.45 \quad ...(1-2)$$

(In Expression (1-2), b represents the concentration of the hydrosilyl group contained in the component (B), and c represents the concentration of the hydrosilyl group contained in the component (C).)

$$E2<70 \quad ...(2).$$

[17] A second agent usable as a thermally conductive composition by mixing with a first agent, the thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and
(F) a platinum group metal-based curing catalyst,

the second agent containing the component (B) and the component (C) but not containing the component (F), the components (B) and (C) being contained to satisfy the relation represented by Expression (1-2) below, and a type E hardness E2 after the first agent and the second agent are mixed, and then are left to stand at 25°C for 24 hours and further at 150°C for 250 hours satisfying Expression (2) below:

$$b/(b+c)>0.45 \quad ...(1\text{-}2)$$

(In Expression (1-2), b represents the concentration of the hydrosilyl group contained in the component (B), and c represents the concentration of the hydrosilyl group contained in the component (C).)

$$E2<70 \quad ...(2).$$

[18] A first agent usable as a thermally conductive composition by mixing with a second agent, the thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and
(F) a platinum group metal-based curing catalyst,

the first agent containing at least one of the components (A) and (D); and the component (F) but not containing the component (B) and the component (C),
the thermally conductive composition containing the components (B) and (C) to satisfy the relation represented by Expression (1-2) below, or the Raman intensity p1 at 2160 $cm^{-1}$ and the Raman intensity p2 at 2130 $cm^{-1}$ in a Raman spectroscopy spectrum satisfying the relation represented by Expression (1-1) below in a case where the first agent is combined with the second agent, and
a type E hardness E2 after the first agent and the second agent are mixed, and then are left to stand at 25°C for 24 hours and further at 150°C for 250 hours satisfying Expression (2) below:

$$p2/p1>3.00 \quad ...(1\text{-}1)$$

$$b/(b+c)>0.45 \quad ...(1\text{-}2)$$

(In Expression (1-2), b represents the concentration of the hydrosilyl group contained in the component (B), and c represents the concentration of the hydrosilyl group contained in the component (C).)

$$E2<70 \quad ...(2).$$

[19] A second agent usable as a thermally conductive composition by mixing with a first agent, the thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and

(F) a platinum group metal-based curing catalyst,

the second agent containing the component (B) and the component (C) but not containing the component (F), the components (B) and (C) being contained to satisfy the relation represented by Expression (1-2) below, or the Raman intensity p1 at 2160 $cm^{-1}$ and the Raman intensity p2 at 2130 $cm^{-1}$ in a Raman spectroscopy spectrum satisfying the relation represented by Expression (1-1) below in a case where the second agent is combined with the first agent, and
a type E hardness E2 after the first agent and the second agent are mixed, and then are left to stand at 25°C for 24 hours and further at 150°C for 250 hours satisfying Expression (2) below:

$$p2/p1>3.00 \quad ...(1-1)$$

$$b/(b+c)>0.45 \quad ...(1-2)$$

(In Expression (1-2), b represents the concentration of the hydrosilyl group contained in the component (B), and c represents the concentration of the hydrosilyl group contained in the component (C).)

$$E2<70 \qquad ...(2).$$

[20] A method including: mixing the first agent according to [14], [16], or [18] with a second agent.
[21] A method including: mixing the second agent according to [15], [17], or [19] with a first agent.
[22] Use of the first agent according to [14], [16], or [18] in a two-pack type thermally conductive composition.
[23] Use of the second agent according to [15], [17], or [19] in a two-pack type thermally conductive composition.

Advantageous Effects of Invention

The thermally conductive composition according to the present invention can provide a thermally conductive member which is less likely to peel off from a heating element and/or a heat-dissipating element and thus less likely to cause an increase in heat resistance even under a use environment at 150°C or more.

Description of Embodiments

[Thermally conductive composition]

Hereinafter, the thermally conductive composition according to the present invention will be specifically described.
The thermally conductive composition according to the present invention comprises the following components (A) to (F). Hereinafter, the components (A) to (F) will be described in detail.

<Component (A)>

The component (A) is an organopolysiloxane having two or more alkenyl groups. The thermally conductive composition, which contains the component (A), can be formed into a cured product having appropriate hardness through an addition reaction of the component (A) with organo-hydrogen polysiloxanes described later. The organopolysiloxane having two or more alkenyl groups used as the component (A) may be linear or branched, or may be a mixture of linear and branched ones. Preferably, the organopolysiloxane is linear.
The alkenyl group in the component (A) may be contained either in a terminal of the chain or in the middle of the chain of the polysiloxane structure of the component (A), or may be contained both in a terminal of the chain and in the middle of the chain. The alkenyl group is preferably contained in at least a terminal of the chain, more preferably contained in both the terminals of the chain composed of the polysiloxane structure, still more preferably contained in only both terminals of the chain.
Examples of the alkenyl group include, but not particularly limited to, $C_2$ to $C_8$ alkenyl groups, and examples thereof include a vinyl group, an allyl group, a butenyl group, a pentenyl group, a hexenyl group, a heptenyl group, and an octenyl group. Among these, a vinyl group is preferred in view of ease in synthesis and reactivity. The alkenyl group is preferably an alkenyl group directly bonded to a silicon atom.
The number of alkenyl groups in one molecule in the component (A) is not particularly limited as long as the

number of alkenyl groups is 2 or more. For example, the number of alkenyl groups is 2 to 4, preferably 2 to 3, more preferably 2.

Examples of groups other than the alkenyl group which are bonded to the silicon atom include alkyl groups such as a methyl group, an ethyl group, a propyl group, a butyl group, a hexyl group, and a dodecyl group; aryl groups such as a phenyl group; and aralkyl groups such as a 2-phenylethyl group and a 2-phenylpropyl group. Other specific examples include substituted hydrocarbon groups such as a chloromethyl group and a 3,3,3-trifluoropropyl group. Among these, a methyl group is preferred in view of ease in synthesis. Of the other groups bonded to the silicon atom, preferably 80 mol% or more, more preferably 90 mol% or more, still more preferably 100 mol% of them is preferably a methyl group. Preferably, the component (A) does not contain a hydrogen atom as the other groups bonded to the silicon atom, that is, the component (A) does not contain a hydrosilyl group.

In the component (A), such organopolysiloxanes may be used singly or in combination.

The viscosity at 25°C of the component (A) is not particularly limited, and is, for example, 80 to 5000 mPa·s, preferably 150 to 2500 mPa·s, more preferably 200 to 1500 mPa·s, still more preferably 250 to 800 mPa·s.

The component (A) may be compounded into a mixture with the component (C) described later in some cases, and the viscosity at 25°C of the mixture of the component (A) and the component (C) is, for example, 80 to 5000 mPa·s, preferably 150 to 2500 mPa·s, more preferably 200 to 1500 mPa·s, still more preferably 250 to 800 mPa·s.

By controlling the viscosity of the component (A) or the mixture of the component (A) and the component (C) to the above-mentioned lower limit or higher, an excessively high cross-linking density of the cured product is prevented, and the flexibility after curing is readily maintained. By controlling the viscosity to the above-mentioned upper limit or lower, an increase in viscosity of the thermally conductive composition can be prevented. Furthermore, by controlling the viscosity within these ranges, the reactivity of the component (A) or the components (A) and (C) is readily controlled to an appropriate level.

In a two-pack type thermally conductive composition, the viscosity at 25°C of the component (A) to be compounded into a first agent may be adjusted to the above viscosity range, or the viscosity at 25°C of the mixture of the component (A) and the component (C) to be compounded into a second agent may be adjusted to the above viscosity range.

The content of the component (A) can be appropriately selected to control the Raman intensity ratio H/Vi, the content ratio H/Vi, the total Vi content, and the ratio of the DVi content to the total Vi content, which will be described later, within desired ranges, and are not particularly limited. The content thereof is, for example, 20 to 70% by mass, preferably 25 to 60% by mass, more preferably 30 to 50% by mass relative to the total amount of organopolysiloxanes contained in the thermally conductive composition.

<Component (B)>

The component (B) is an organo-hydrogen polysiloxane having two hydrosilyl groups. The thermally conductive composition, which contains the component (B), can be formed into a cured product having appropriate hardness because of chains extended through addition reaction of the component (B) with the components (A) and (D). The thermally conductive composition according to the present invention, which contains not only the component (C) described later but also the component (B) as the organo-hydrogen polysiloxanes, can be formed into a cured product having appropriate flexibility because the density of cross-linking points is not excessively increased.

The component (B) may be linear or branched, or may be a mixture of linear and branched ones. Preferably, the component (B) is linear. The hydrosilyl group in the component (B) may be contained either in a terminal of the chain of the polysiloxane structure or in the middle of the chain, or may be contained both in a terminal of the chain and in the middle of the chain. Preferably, the hydrosilyl group is contained in at least a terminal, and more preferably, two hydrosilyl groups are contained in both terminals of the chain of the polysiloxane structure, respectively.

In the component (B), examples of other groups bonded to the silicon atom than the hydrosilyl group include alkyl groups such as a methyl group, an ethyl group, a propyl group, a butyl group, a hexyl group, and a dodecyl group; aryl groups such as a phenyl group; and aralkyl groups such as a 2-phenylethyl group and a 2-phenylpropyl group. Other specific examples include substituted hydrocarbon groups such as a chloromethyl group and a 3,3,3-trifluoropropyl group. Among these, a methyl group is preferred in view of ease in synthesis. Of the other groups bonded to the silicon atom, preferably 80 mol% or more, more preferably 90 mol% or more, still more preferably 100 mol% of them is a methyl group. Preferably, the component (B) does not contain an alkenyl group as other groups bonded to the silicon atom, that is, the component (B) does not contain an alkenyl group.

In the component (B), such organopolysiloxanes may be used singly or in combination.

The viscosity at 25°C of the component (B) is not particularly limited, and is, for example, 10 to 2000 mPa·s, preferably 40 to 1500 mPa·s, more preferably 80 to 1200 mPa·s. By controlling the viscosity of the component (B) to the above-mentioned lower limit or higher, an increase in cross-linking density is easily prevented to obtain favorable flexibility after curing. In addition, excessive acceleration of the reactivity is easily prevented to allow the addition reaction to

appropriately progress. By controlling the viscosity of the component (B) to the above-mentioned upper limit or lower, a reduction in reactivity and an increase in viscosity of the thermally conductive composition can be prevented.

The content of the component (B) is not particularly limited as long as the content is appropriately selected to adjust the Raman intensity ratio p2/p1, the Raman intensity ratio H/Vi, b/(b+c), and the content ratio H/Vi, which will be described later, within predetermined ranges. For example, the content is 3 to 35% by mass, preferably 5 to 30% by mass, more preferably 8 to 25% by mass.

<Component (C)>

The component (C) is an organo-hydrogen polysiloxane having three or more hydrosilyl groups. The component (C) can cause an addition reaction with the components (A) and (D) to cure the thermally conductive composition and also form a cross-linked structure in the cured product.

The component (C) may be linear or branched, or may be a mixture of linear and branched ones. Preferably, the component (C) is linear. The hydrosilyl group in the component (C) may be contained either in a terminal of the chain of the polysiloxane structure or in the middle of the chain. Preferably, the hydrosilyl groups are contained in both the terminal of the chain and in the middle of the chain.

The number of hydrosilyl groups in one molecule of the component (C) is not particularly limited as long as the number is 3 or more. For example, the number thereof is 3 to 25, preferably 8 to 20.

Examples of other groups bonded to the silicon atom in the component (C) include the same as those listed for the component (B). In view of ease in synthesis, a methyl group is preferred. Of the other groups bonded to the silicon atom, preferably 80 mol% or more, more preferably 90 mol% or more, still more preferably 100 mol% of them is a methyl group. Preferably, the component (C) does not contain an alkenyl group as other groups bonded to the silicon atom, that is, the component (C) does not contain an alkenyl group.

In the component (C), such organopolysiloxanes may be used singly or in combination.

The content of the component (C) is not particularly limited as long as the content is appropriately selected to adjust the Raman intensity ratio p2/p1, the Raman intensity ratio H/Vi, b/(b+c), and the content ratio H/Vi, which will be described later, within predetermined ranges. For example, the content is 0.2 to 8% by mass, preferably 0.4 to 5% by mass, more preferably 0.7 to 3% by mass.

<Component (D)>

The component (D) is an organopolysiloxane having one alkenyl or methacryloyl group. Since the thermally conductive composition contains the component (D), an excessive increase in density of cross-linking points can be prevented, so that favorable flexibility of the cured product can be maintained even when the cured product is used under an environment at 150°C or more, leading to improved reliability. For this reason, when the cured product of the thermally conductive composition is used as a heat-dissipating gap filler under an environment at 150°C or more, peel off of the cured product from the heating element and/or the heat-dissipating element can be suppressed, and thus an increase in heat resistance can be suppressed. Furthermore, since the cured product has increased flexibility after curing, it can exhibit buffer properties when it has an increased thickness. Such a cured product can be suitably used under an environment where vibration occurs. The component (D) causes an addition reaction with component (B) or (C) during curing, and thus bleed out after curing can also be prevented.

The organopolysiloxane used as the component (D) may be linear or branched, or may be a mixture of linear and branched ones. Preferably, the component (D) is a linear organopolysiloxane.

The alkenyl or methacryloyl group may be contained either in a terminal of the chain of the polysiloxane structure or in the middle of the chain, and is contained preferably in a terminal of the chain, more preferably in one of the terminals of the chain of the polysiloxane structure. The component (D) preferably contains either one of an alkenyl group or a methacryloyl group in the molecule. To obtain a cured product having high heat resistance, the component (D) preferably contains one methacryloyl group.

Examples of the alkenyl group in the component (D) include, but not particularly limited to, $C_2$ to $C_8$ alkenyl groups, and specific examples thereof include those listed for the component (A). In view of ease in synthesis, a vinyl group is preferred. The alkenyl group is preferably an alkenyl group directly bonded to a silicon atom.

On the other hand, the methacryloyl group can be a methacryloyl group directly bonded to a silicon atom, or it may be bonded to a silicon atom through any divalent group (for example, a divalent saturated aliphatic hydrocarbon group, or a group represented by - XO- (where X is a divalent saturated aliphatic hydrocarbon group)) or an oxygen atom.

Examples of other groups bonded to the silicon atom in the component (D) include the same as those listed for the component (A). In view of ease in synthesis, a methyl group is preferred. Of the other groups bonded to the silicon atom, preferably 80 mol% or more, more preferably 90 mol% or more, still more preferably 100 mol% of them is a methyl group. The component (D) does not contain a hydrogen atom as other groups bonded to the silicon atom, that is, preferably, the

component (D) does not contain a hydrosilyl group.

In the component (D), such organopolysiloxanes may be used singly or in combination.

The viscosity at 25°C of the component (D) is not particularly limited, and is, for example, 10 to 2000 mPa·s, preferably 50 to 1000 mPa·s, more preferably 80 to 600 mPa·s.

By controlling the viscosity of the component (D) to the above-mentioned lower limit or higher, the cured product is likely to have a reduced cross-linking density, and the flexibility after curing is readily enhanced. By controlling the viscosity thereof to the above-mentioned upper limit or lower, an increase in viscosity of the thermally conductive composition can be prevented. In addition, by controlling the viscosity of the component (D) within the ranges above, the component (D) can be adjusted to have appropriate reactivity.

The content of the component (D) is not particularly limited as long as the content is appropriately selected to adjust the Raman intensity ratio H/Vi, the content ratio H/Vi, the total Vi content, and the ratio of the DVi content to the total Vi content, which will be described later, within desired ranges. For example, the content is 1 to 30% by mass, preferably 5 to 25% by mass, more preferably 8 to 20% by mass relative to the total amount of organopolysiloxanes contained in the thermally conductive composition.

<Component (E)>

The component (E) is a thermally conductive filler. Since the thermally conductive composition according to the present invention contains the thermally conductive filler, the thermally conductive composition and a cured product (thermally conductive member) formed through curing of the thermally conductive composition have improved thermal conductivity.

Examples of the thermally conductive filler include metals, metal oxides, metal nitrides, metal hydroxides, carbon materials, and oxides, nitrides, and carbides of substances other than metals. Examples of the form of the thermally conductive filler include spherical and amorphous powders.

Examples of metals for the thermally conductive filler include aluminum, copper, and nickel. Examples of metal oxides include aluminum oxide represented by alumina, magnesium oxide, and zinc oxide. Examples of metal nitrides include aluminum nitride. Examples of metal hydroxides include aluminum hydroxide. Examples of carbon materials include spherical graphite and diamond. Examples of oxides, nitrides, and carbides of substances other than metals include quartz, boron nitride, and silicon carbide. Among these, metal oxides, metal nitrides, and carbon materials are preferred, and among these, metal oxides are more preferred thermally conductive filler in view of improving thermal conductivity. Specifically, aluminum oxide, aluminum nitride, and diamond are preferred, and aluminum oxide is more preferred.

These thermally conductive fillers may be used singly or in combination. For example, in view of improving thermal conductivity, it is preferable to use at least one of diamond and aluminum nitride in combination with aluminum oxide. In view of the balance between the thermal conductivity and the flame retardancy, it is preferable to use aluminum oxide in combination with aluminum hydroxide.

The thermally conductive filler has an average particle size of 0.1 to 200 μm, preferably 0.3 to 100 μm, more preferably 0.5 to 70 μm.

The thermally conductive filler is preferably a combination of a thermally conductive filler having a small average particle size of 0.1 μm or more and 5 μm or less and a thermally conductive filler having a large average particle size of more than 5 μm and 200 μm or less. Use of thermally conductive fillers having different average particle sizes can increase the filling ratio. The average particle size indicates the 50th percentile of the volume-weighted particle size distribution (D50) of the thermally conductive filler determined by a laser diffraction/scattering method.

The content of the thermally conductive filler in the thermally conductive composition is preferably 150 to 4000 parts by mass, more preferably 500 to 3500 parts by mass, still more preferably 1000 to 3200 parts by mass, further still more preferably 1500 to 3000 parts by mass per 100 parts by mass of organopolysiloxanes contained in the thermally conductive composition.

The volume-based content of the thermally conductive filler is preferably 50 to 95% by volume, more preferably 70 to 93% by volume, still more preferably 75 to 92% by volume, further still more preferably 80 to 90% by volume relative to the total amount of the thermally conductive composition, which is regarded as 100% by volume.

By controlling the content of the thermally conductive filler to the above-mentioned lower limit or higher, predetermined thermal conductivity can be imparted to the thermally conductive composition and its cured product. By controlling the content of the thermally conductive filler to the above-mentioned upper limit or lower, the thermally conductive filler can be appropriately dispersed. An excessive increase in viscosity of the thermally conductive composition can be also prevented.

<Component (F)>

The component (F) is a platinum group metal-based curing catalyst. Since the thermally conductive composition according to the present invention contains the platinum group metal-based curing catalyst, an addition reaction of an organopolysiloxane having an alkenyl group with an organo-hydrogen polysiloxane can be promoted to appropriately cure the thermally conductive composition. Examples of the platinum group metal-based curing catalyst include, but not particularly limited to, chloroplatinic acid, and complexes of chloroplatinic acid with olefins, vinyl siloxane, or an acetylene compound. The platinum group metal-based curing catalyst can be contained in the thermally conductive composition in an amount for promoting the addition reaction, and the amount is not particularly limited. For example, the amount is 0.001 to 1 part by mass, preferably 0.005 to 0.5 parts by mass per 100 parts by mass of organopolysiloxanes contained in the thermally conductive composition.

<Component (G)>

Preferably, the thermally conductive composition according to the present invention further contain an organopolysiloxane having no addition reactive group as the component (G). When the thermally conductive composition according to the present invention contains the component (G), a certain amount or more of components is not integrated into the cross-linked structure of the cured product, thus facilitating an improvement in flexibility. **In** addition, a reduction in viscosity of the thermally conductive composition is facilitated, and thus an improvement in handling properties is facilitated. The addition reactive group refers to a functional group reactive in an addition reaction, and typical examples thereof include alkenyl groups, a methacryloyl group, an acryloyl group, and a hydrosilyl group. When the component (G) is contained, a cured product can have flexibility.

Examples of the component (G) include (G-1) silicone oil and (G-2) an organopolysiloxane having at least one alkoxy group. The component (G) may contain one of the component (G-1) and the component (G-2). Preferably, the component (G) contains at least the component (G-2). When the component (G) contains the component (G-2), the thermally conductive composition highly tends to have a reduced viscosity. When containing the component (G-2), the thermally conductive composition may further contain the component (G-1).

Examples of (G-1) silicone oil include straight silicone oils such as dimethyl silicone oil and phenylmethyl silicone oil, and also non-reactive modified silicone oils having a non-reactive organic group introduced to the main chain of the polysiloxane structure, the side chain bonded to the main chain, or the terminal(s) of the main chain. The non-reactive organic group is an organic group having no addition reactive group. Examples of non-reactive modified silicone oils include polyether-modified silicone oil, aralkyl-modified silicone oil, fluoroalkyl-modified silicone oil, long-chain alkyl-modified silicone oil, higher fatty acid ester-modified silicone oil, higher fatty acid amide-modified silicone oil, and phenyl-modified silicone oil. Among these silicone oils, straight silicone oils are preferred, and among the straight silicone oils, dimethyl silicone oil is more preferred.

As (G-1) silicone oil, these silicone oils can be used singly or in combination.

The component (G-2) may be linear or branched, or may be a mixture of linear and branched ones. Preferably, the component (G-2) is linear. The component (G-2) can be any organopolysiloxane having at least one alkoxy group, and is preferably an organopolysiloxane having at least one alkoxy group at the chain terminal of the polysiloxane structure, more preferably an organopolysiloxane having at least one alkoxy group only at one terminal thereof. The component (G-2), which has an alkoxy group, is likely to react or interact with the functional group present on the surface of the thermally conductive filler, particularly when it has an alkoxy group at the terminal. Moreover, the component (G-2) has a polysiloxane structure. For these reasons, it is inferred that the friction of the filler is reduced, facilitating a reduction in viscosity of the thermally conductive composition.

Specifically, the component (G-2) preferably has a structure represented by Formula (X) below:

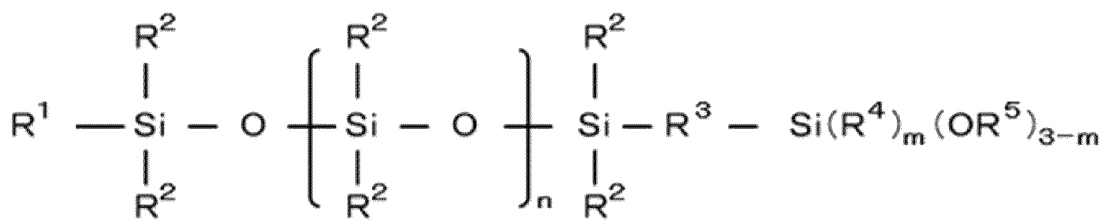

(X)

wherein $R^1$, $R^2$, $R^4$, and $R^5$ each independently represent a saturated hydrocarbon group, $R^3$ represents an oxygen atom or a divalent hydrocarbon group, n is an integer of 15 to 315, and m is an integer of 0 to 2.

Use of the component (G-2) having the structure represented by Formula (X) further enhance the effect of reducing the viscosity of the thermally conductive composition.

In Formula (X), $R^1$, $R^2$, $R^4$, and $R^5$ each independently represent a saturated hydrocarbon group. Examples of the saturated hydrocarbon group include alkyl groups such as linear alkyl groups, branched alkyl groups, and cyclic alkyl groups, aryl groups, aralkyl groups, and alkyl halide groups.

Examples of linear alkyl groups include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, and an eicosyl group. Examples of branched alkyl groups include an isopropyl group, a tertiary butyl group, an isobutyl group, a 2-methylundecyl group, and a 1-hexylheptyl group. Examples of cyclic alkyl groups include a cyclopentyl group, a cyclohexyl group, and a cyclododecyl group.

Examples of aryl groups include a phenyl group, a tolyl group, and a xylyl group. Examples of aralkyl groups include a benzyl group, a phenethyl group, and a 2-(2,4,6-trimethylphenyl)propyl group. Examples of alkyl halide groups include a 3,3,3-trifluoropropyl group and a 3-chloropropyl group.

In Formula (X), $R^1$ to $R^5$, m, and n are preferably as defined below, in view of enhancing the viscosity reduction effect.

In Formula (X), $R^1$ is preferably a $C_1$ to $C_8$ alkyl group, more preferably a $C_2$ to $C_6$ alkyl group, particularly preferably a butyl group.

In Formula (X), $R^2$, $R^4$, and $R^5$ each independently is preferably a $C_1$ to $C_8$ alkyl group, more preferably a $C_1$ to $C_4$ alkyl group, particularly preferably a methyl group.

In Formula (X), $R^3$ is an oxygen atom or a divalent hydrocarbon group, preferably a divalent hydrocarbon group. Examples of divalent hydrocarbon groups include a methylene group, an ethylene group, a propylene group, a butylene group, and a methylethylene group. Among these, an ethylene group is preferred.

In Formula (X), n is an integer of 15 to 315, preferably an integer of 18 to 280, more preferably an integer of 20 to 220. In Formula (X), m is an integer of 0 to 2, preferably 0 or 1, more preferably 0. Accordingly, the component (G-2) is preferably an organopolysiloxane having a trialkoxysilyl group at one terminal.

As the component (G-2), these may be used singly or in combination.

The viscosity at 25°C of the component (G) is not particularly limited, and is, for example, 1 to 800 mPa·s, preferably 5 to 250 mPa·s, more preferably 10 to 150 mPa·s. When the viscosity of the component (G) is the above ranges, the component (G) effectively reduces the viscosity of the thermally conductive composition, and at the same time, the cured product is readily formed.

The content of the component (G) in the thermally conductive composition is, for example, 3 to 63% by mass relative to the total amount of organopolysiloxanes contained in the thermally conductive composition. By controlling the content of the component (G) to the above-mentioned lower limit or higher, the cured product formed from the thermally conductive composition is likely to have increased flexibility, and a reduction in viscosity of the thermally conductive composition is facilitated by the component (G). By controlling the content of the component (G) to the above-mentioned upper limit or lower, certain curability can be imparted to the thermally conductive composition, facilitating formation of a cured product having desired physical properties, and bleed out after curing is also prevented easily. The content of the component (G) in the thermally conductive composition is preferably 5 to 50% by mass, more preferably 10 to 40% by mass, still more preferably 15 to 35% by mass.

As described above, the component (G) preferably contains the component (G-2). The content of the component (G-2) in the thermally conductive composition is preferably 2 to 40% by mass, more preferably 4 to 30% by mass, still more preferably 8 to 20% by mass relative to the total amount of organopolysiloxanes contained in the thermally conductive composition. When the thermally conductive composition contains a predetermined amount or larger of the component (G-2) of the component (G), it is more likely to reduce the viscosity of the thermally conductive composition.

In the thermally conductive composition according to the present invention, the total content of the components (A) to (D) and (G) is preferably 2 to 40% by mass relative to the total amount of the thermally conductive composition. By adjusting the total amount of the components (A) to (D) and (G) to be a predetermined amount or larger, these components can appropriately demonstrate their functions as the binder resins, and can appropriately hold the thermally conductive filler. By adjusting the total content to be a predetermined amount or smaller, a large amount of the thermally conductive filler can be contained.

The total content of the components (A) to (D) and (G) is more preferably 3 to 20% by mass, still more preferably 3.5 to 15% by mass, further still more preferably 4 to 10% by mass relative to the total amount of the thermally conductive composition.

The organopolysiloxanes in the thermally conductive composition according to the present invention may consist of the components (A) to (D) or the components (A) to (D) and (G), and may also contain a different organopolysiloxane from the components (A) to (D) and (G) as long as the effects of the present invention are not impaired. The content of the different organopolysiloxane from the components (A) to (D) and (G) is, for example, 30% by mass or less, preferably 20% by mass or less, more preferably 10% by mass or less, still more preferably 5% by mass or less, most preferably 0% by mass relative to the total amount of organopolysiloxanes contained in the thermally conductive composition.

The thermally conductive composition according to the present invention can contain a variety of additives. Examples of such additives include a reaction controller, a dispersant, a flame retardant, a plasticizer, an antioxidant, and a colorant. In the two-pack type thermally conductive composition, each additive may be contained in one of the first agent and the second agent, or may be contained in both of them. One or more additives may be appropriately selected from these additives and used.

<Raman intensity ratio p2/p1>

In the thermally conductive composition according to one embodiment of the present invention, the Raman intensity p1 at 2160 $cm^{-1}$ and the Raman intensity p2 at 2130 $cm^{-1}$ in the Raman spectroscopy spectrum satisfy the relation represented by Expression (1-1) below:

$$p2/p1>3.00 \ ...(1\text{-}1).$$

The Raman intensity p1 at 2160 $cm^{-1}$ in the Raman spectroscopy spectrum is the Raman intensity at the wavelength of the peak assigned to a hydrosilyl group contained in the middle of a chain of the polysiloxane structure. The Raman intensity p2 at 2130 $cm^{-1}$ in the Raman spectroscopy spectrum is the Raman intensity at the wavelength of the peak assigned to a hydrosilyl group contained in a terminal of a chain of the polysiloxane structure. Thus, it can be said that p2/p1 is an index indicating the amount of the terminal hydrosilyl groups relative to that of the hydrosilyl groups contained in the middle of chains.

When p2/p1 is larger than 3.0, the amount of the hydrosilyl group contained in the terminal of the chain is large while the amount of the hydrosilyl group contained in the middle of the chain is small. As a result, the density of cross-linking points tends to be reduced, and it is thus likely that favorable flexibility of the cured product is maintained even when the cured product is placed under an environment at 150°C or more. Accordingly, when the cured product of the thermally conductive composition is used as a heat-dissipating gap filler under an environment at 150°C or more, the cured product is less likely to peel off from the heating element and/or the heat-dissipating element, obstructing occurrence of failures such as increased heat resistance and improving the reliability. Furthermore, if the cured product has increased flexibility, it can exhibit buffer properties when the cured product has a large thickness. Such a cured product can be suitably used under an environment where vibration occurs.

In view of reducing the density of cross-linking points to obtain more favorable reliability and flexibility, p2/p1 is preferably 3.10 or more, more preferably 3.20 or more, still more preferably 3.30 or more.

Preferably, p2/p1 is less than 5.5. When p2/p1 is less than 5.5, a three-dimensional cross-linked structure is readily introduced into the cured product with an appropriate cross-linking density. Accordingly, the hardness is likely to be kept at a predetermined value even when the cured product is heated at a high temperature for a long time, and favorable long-term heat resistance is thus likely to be obtained. From such a viewpoint, p2/p1 is more preferably less than 4.5, still more preferably 4.2 or less, further still more preferably 4.0 or less.

The value of the Raman intensity ratio p2/p1 can be controlled by adjusting the content of the component (B), the concentration of the hydrosilyl group at the chain terminal of the component (B), the content of the component (C), and the concentration of the hydrosilyl group in the middle of the chain of the component (C). Specifically, the value of p2/p1 can be increased by any one or a combination of increasing the content of the component (B), increasing the concentration of the hydrosilyl group at the chain terminal contained in the component (B), reducing the content of the component (C), and reducing the concentration of the hydrosilyl group in the middle of the chain contained in the component (C). The value of p2/p1 can be reduced by any of opposite control manners.

<Raman intensity ratio H/Vi>

In the Raman spectroscopy spectrum, the ratio of the intensity of the peak assigned to the hydrosilyl group to the intensity of the peaks assigned to the alkenyl group and the methacryloyl group (also referred to as "Raman intensity ratio H/Vi") is, for example, 7.00 to 13.50, preferably 7.00 to 12.00, more preferably 7.50 to 11.00. When the Raman intensity ratio H/Vi is the above range, the number of hydrosilyl groups and the total number of alkenyl groups and methacryloyl groups are balanced, so that the components (A) to (D) are likely to be appropriately cured, and for example, curing is likely to appropriately progress even under normal temperature.

The value of the Raman intensity ratio H/Vi can be controlled by adjusting the content of the component (A), the content of the component (B), the content of the component (C), the content of the component (D), and the concentrations of the alkenyl group, the methacryloyl group, and the hydrosilyl group in these components. Specifically, the value of H/Vi can be increased by any one or a combination of reducing the content of the component (A), reducing the content of the component (D), reducing the concentration of the alkenyl group in the component (A), reducing the total concentration of

the alkenyl group and the methacryloyl group in the component (D), increasing the content of the component (B), increasing the content of the component (C), increasing the concentration of the hydrosilyl group contained in the component (B), and increasing the concentration of the hydrosilyl group contained in the component (C). The value of H/Vi can be reduced by any of opposite control manners.

For obtaining the Raman spectroscopy spectrum of the thermally conductive composition, at least the organopolysiloxanes may be separated from the thermally conductive filler, and the organopolysiloxanes may be subjected to Raman spectroscopy. At this time, the organopolysiloxanes may be contaminated with a component other than the organopolysiloxanes as long as the component does not affect the spectroscopy. Thus, usually, a liquid component may be separated from a solid component by centrifuge, for example, and the liquid component may be subjected to Raman spectroscopy to obtain a spectrum.

For the two-pack type thermally conductive composition, the first agent and the second agent can be separately subjected to Raman spectroscopy, and the Raman intensity ratio p2/p1 and H/Vi can be calculated. Preferably, the Raman intensity ratio p2/p1 is calculated from the Raman spectroscopy spectrum of the second agent. This is because the organo-hydrogen polysiloxanes are not contained in the first agent, and are contained only in the second agent. The conditions for Raman spectroscopy are as described in Examples. It is noted that the alkenyl group is typically a vinyl group, and typically, the Raman intensity ratio H/Vi can be obtained by calculating, as an index, the ratio of the hydrosilyl group to (vinyl group + methacryloyl group) as shown in Examples described later.

In the present invention, "combining the first agent with the second agent" or "combining the second agent with the first agent" means that calculation is performed by using the values obtained by subjecting the first agent and the second agent separately to measurement as described above.

<Hydrosilyl group concentration ratio>

In the thermally conductive composition according to one embodiment of the present invention, the component (B) and the component (C) are contained to satisfy the relation represented by Expression (1-2) below:

$$b/(b+c)>0.45 \quad ...(1\text{-}2)$$

In Expression (1-2), b represents the concentration of the hydrosilyl group contained in the component (B), and c represents the concentration of the hydrosilyl group contained in the component (C). The concentration of the hydrosilyl group herein indicates the concentration of the hydrosilyl group in the thermally conductive composition. It is noted that, in the two-pack type thermally conductive composition described later, the organo-hydrogen polysiloxanes are not contained in the first agent, and are contained only in the second agent. Thus, it can also be said that in the two-pack type thermally conductive composition, the concentration of the hydrosilyl group indicates the concentration of the hydrosilyl group in the second agent. In other words, the component (B) and the component (C) can be contained in the second agent to satisfy the relation represented by Expression (1-2).

The hydrosilyl group concentration ratio can be controlled by adjusting the content of the component (B), the concentration of the hydrosilyl group in the component (B), the content of the component (C), and the concentration of the hydrosilyl group in the component (C). Specifically, the hydrosilyl group concentration ratio can be increased by any one or a combination of increasing the content of the component (B), increasing the concentration of the hydrosilyl group contained in the component (B), reducing the content of the component (C), and reducing the concentration of the hydrosilyl group contained in the component (C). The hydrosilyl group concentration ratio can be reduced by any of opposite control manners.

In this composition, when b/(b+c) is larger than 0.45, the density of cross-linking points tends to be reduced, and it is thus likely that favorable flexibility of the cured product is maintained even when the cured product is placed under an environment at 150°C or more. Accordingly, when the cured product of the thermally conductive composition is used as a heat-dissipating gap filler under an environment at 150°C or more, the cured product is less likely to peel off from the heating element and/or the heat-dissipating element, obstructing occurrence of failures such as increased heat resistance and improving the reliability. Furthermore, if the cured product has increased flexibility, it can exhibit buffer properties when the cured product has a large thickness. Such a cured product can be suitably used under an environment where vibration occurs.

In view of reducing the density of cross-linking points to obtain more favorable reliability and flexibility, b/(b+c) is preferably 0.48 or more, more preferably 0.50 or more, still more preferably 0.52 or more.

b/(b+c) is preferably less than 0.85. When b/(b+c) is less than 0.85, a cross-linked structure is readily introduced into the cured product in an appropriate cross-linking density. Accordingly, the hardness is likely to be kept at a predetermined value even when the cured product is heated at a high temperature for a long time, and favorable long-term heat resistance is thus likely to be obtained. From such a viewpoint, b/(b+c) is more preferably 0.75 or less, still

more preferably 0.70 or less, further still more preferably 0.63 or less.

In the present invention, one of the requirement defined by Expression (1-1) and the requirement defined by Expression (1-2) may be satisfied, or both of them may be satisfied.

The concentrations of the hydrosilyl groups in the component (B) and the component (C) can be values calculated from the integral ratio in the 1H-NMR spectrum obtained using an NMR analyzer.

<Content of alkenyl group and methacryloyl group>

The total content of the alkenyl group and the methacryloyl group in the thermally conductive composition (hereinafter, also referred to as "total Vi content") is preferably 5.0 μmol/g or less. When the total Vi content is 5.0 μmol/g or less, a cured product having a reduced cross-linking density and favorable flexibility is likely to be obtained. The total Vi content is more preferably 4.8 μmol/g or less, still more preferably 4.5 μmol/g or less, further still more preferably 4.2 μmol/g or less.

To impart predetermined curability and an appropriate cross-linking density to the thermally conductive composition, the total Vi content is preferably 0.5 μmol/g or more, more preferably 1.0 μmol/g or more, still more preferably 2.0 μmol/g or more, further still more preferably 3.0 μmol/g or more.

The content of the alkenyl group can be a value calculated from the integral ratio in the 1H-NMR spectrum obtained using an NMR analyzer.

The total content of the alkenyl group and the methacryloyl group contained in the component (D) (i.e., organopolysiloxane having one alkenyl or methacryloyl group) (hereinafter, also referred to as "DVi content") is preferably 0.05 or more relative to the total Vi content. When the amount of the alkenyl group and the methacryloyl group in the component (D) is the predetermined amount or more, an excessive increase in density of cross-linking points is prevented, facilitating an improvement in flexibility and reliability. The DVi content is preferably 0.10 or more, more preferably 0.15 or more, still more preferably 0.19 or more relative to the total Vi content. In view of imparting predetermined curability and appropriate cross-linking density to the cured product, the DVi content is preferably 0.40 or less, more preferably 0.35 or less, still more preferably 0.30 or less, further still more preferably 0.28 or less relative to the total Vi content.

The total content of the alkenyl group and the methacryloyl group can be controlled by adjusting the content of the component (A), the content of the component (D), the concentration of the alkenyl group in the component (A), and the concentrations of the alkenyl group and the methacryloyl group in the component (D). Specifically, the total content of the alkenyl group and the methacryloyl group can be increased by any one or a combination of increasing the content of the component (A), increasing the content of the component (D), increasing the concentration of the alkenyl group in the component (A), and increasing the total concentration of the alkenyl group and the methacryloyl group in the component (D). The total content of the alkenyl group and the methacryloyl group can be reduced by any of opposite control manners.

The total content of the alkenyl group and the methacryloyl group contained in the component (D) can be controlled by adjusting the content of the component (D) and the concentrations of the alkenyl group and the methacryloyl group in the component (D). Specifically, the total content of the alkenyl group and the methacryloyl group contained in the component (D) can be increased by any one or a combination of increasing the content of the component (D) and increasing the total concentration of the alkenyl group and the methacryloyl group in the component (D). The total content of the alkenyl group and the methacryloyl group contained in the component (D) can be reduced by any of opposite control manners.

<Content ratio H/Vi>

In the thermally conductive composition, the content H of the hydrosilyl group and the total content Vi of the alkenyl group and the methacryloyl group preferably satisfy the relation represented by Expression (4) below:

$$0.85 \leq H/Vi \leq 1.1 \quad ....(4).$$

When the relation represented by Expression (4) is satisfied, favorable curability of the thermally conductive composition can be obtained, and for example, the thermally conductive composition can be appropriately cured even at normal temperature. In view of the curability, H/Vi is more preferably 0.90 to 1.05, still more preferably 0.95 to 1.03.

The hydrosilyl group concentration ratio (b/(b+c)), the total Vi content, the DVi content, and the content ratio H/Vi described above can be calculated from the amounts of the functional groups of the components contained and the contents of the components.

The value of the content ratio H/Vi can be controlled in the same manner(s) as for controlling the Raman intensity ratio H/Vi.

<Type E hardness>

The type E hardness (E2) of the thermally conductive composition according to the present invention, after the composition is left to stand at 25°C for 24 hours and further at 150°C for 250 hours, satisfies Expression (2) below:

$$E2<70 \qquad ...(2).$$

In a case where the thermally conductive composition is a two-pack type thermally conductive composition, the first agent and the second agent can be mixed, and left to stand at 25°C for 24 hours. The same is applied to the measurement of the hardness in other conditions.

When the type E hardness (E2) is 70 or more, the flexibility of the cured product is likely to be maintained under an environment at 150°C or more, but the cured product is excessively hard, which leads to difficulties in relaxing stress such as vibration. This is likely to cause peel off of the cured product from the heating element and/or the heat-dissipating element. For this reason, when the cured product of the thermally conductive composition is used as a heat-dissipating gap filler (thermally conductive member) under an environment at 150°C or more, the cured product peels off from the heating element and/or the heat-dissipating element, resulting failures such as increased heat resistance and reducing the reliability. In view of the flexibility and the reliability, the type E hardness (E2) is preferably 69 or less, more preferably 67 or less, still more preferably 64 or less. When the flexibility is increased, the cured product is likely to exhibit buffer properties, and can be suitably used under an environment where vibration occurs.

The type E hardness (E2) is, for example, 30 or more, preferably 40 or more, more preferably 50 or more, but is not particularly limited thereto. By controlling the type E hardness (E2) to a predetermined value or larger, the cured product can readily maintain flexibility under an environment at 150°C or more, and, for example, can sufficiently hold the weight of a member disposed on the cured product to prevent excessive compression of the cured product in the thickness direction when used.

The type E hardness (E2) can be controlled by adjusting the concentrations of the components, the concentrations of the alkenyl group, the methacryloyl group, and the hydrosilyl group in the components, the Raman intensity ratio H/Vi, and the content ratio H/Vi, for example. Specifically, E2 can be increased by any one or a combination of increasing the content of the component (A), increasing the content of the component (C), increasing the concentration of the alkenyl group in the component (A), increasing the concentration of the hydrosilyl group in the component (C), and controlling the Raman intensity ratio H/Vi and the content ratio H/Vi within more preferred ranges. On the other hand, E2 can be reduced by increasing the content of the component (B), increasing the content of the component (D), adding a large amount of the component (G) as needed, reducing the concentrations of the alkenyl group, the methacryloyl group, and the hydrosilyl group in the components, and controlling the Raman intensity ratio H/Vi and the content ratio H/Vi out of more preferred ranges.

Preferably, the type E hardness (E1) after the thermally conductive composition is left to stand at 25°C for 24 hours and the E2 satisfy the relation represented by Expression (3) below:

$$1.4 \leq E2/E1 \leq 3.5 \qquad ...(3).$$

When E2/E1 is 1.4 or more, a cured product having flexibility and predetermined heat resistance at the same time can be obtained. When E2/E1 is 3.5 or less, the hardness after curing does not excessively change, so that stable fixation is allowed.

E2/E1 is more preferably 1.8 or more, and more preferably 3.0 or less.

The type E hardness (E1) after the thermally conductive composition is left to stand at 25°C for 24 hours is preferably 10 or more, more preferably 15 or more, still more preferably 20 or more. When the type E hardness (E1) of the thermally conductive composition is the predetermined value or larger, a cured product having predetermined hardness can be obtained only by leaving such a thermally conductive composition at normal temperature. Thus, for example, such a cured product in a state after being cured at normal temperature can sufficiently hold the weight of a member disposed on the cured product to prevent compression thereof in the thickness direction when used. The type E hardness (E1) of the thermally conductive composition is preferably 50 or less, more preferably 46 or less, still more preferably 40 or less. By controlling the type E hardness (E1) to the above-mentioned upper limit or lower, the cured product of the thermally conductive composition can have improved flexibility.

To control the relation between the type E hardness (E1) and the E2 within the predetermined range, for example, the Raman intensity ratio p2/p1 or the Raman intensity ratio H/Vi can be controlled to a predetermined range, and also the component (F) can be added in a predetermined amount to avoid an excessively slow curing reaction.

The type E hardness after the cured product is left to stand at 25°C for 24 hours and further at 150°C for 1000 hours is designated as E3. A change in hardness represented by the value of E3-E2 indicates a change in hardness when

the cured product is heated at 150°C for a long time. A smaller value of E3-E2 indicates a smaller change in performance and therefore more favorable long-term heat resistance even when the cured product is used at a temperature of 150°C or more for a long time. In view of the long-term heat resistance, the change in hardness represented by the value of E3-E2 is preferably 6 or less, more preferably 4 or less, still more preferably 2 or less. The change in hardness represented by the value of E3-E2 is usually 0 or more, but is not particularly limited thereto.

[Two-pack type thermally conductive composition]

The thermally conductive composition according to the present invention may be a one-pack type, or may be a two-pack type composed of a combination of a first agent and a second agent. In view of the storage stability, the two-pack type is preferred. The two-pack type thermally conductive composition is prepared by mixing the first agent with the second agent when used.

In the two-pack type thermally conductive composition, the mass ratio between the first agent and the second agent (second agent/first agent) is preferably 1 or a value close to 1, more preferably 0.8 to 1.2, more preferably 0.9 to 1.1, still more preferably 0.95 to 1.05. When the mass ratio between the first agent and the second agent is 1 or a value close to 1 as above, preparation of the thermally conductive composition is easy.

For the two-pack type thermally conductive composition, there is no limitation on the method for mixing the first agent with the second agent to prepare a thermally conductive composition. For example, a static mixer, a mixer having a stirring blade, a vibration stirrer, or a planetary mixer can be used.

In the two-pack type thermally conductive composition, the first agent contains an organopolysiloxane having an alkenyl group (alkenyl group-containing organopolysiloxane) and (F) the platinum group metal-based curing catalyst, and does not contain an organo-hydrogen polysiloxane. The second agent contains an organo-hydrogen polysiloxane, and does not contain (F) the platinum group metal-based curing catalyst. Furthermore, at least one of the first agent and the second agent contains (E) the thermally conductive filler. Preferably, both of the first agent and the second agent contain (E) the thermally conductive filler.

More specifically, the first agent contains at least one of the components (A) and (D) and the component (F), and does not contain the component (B) and the component (C). On the other hand, the second agent contains the component (B) and the component (C), and does not contain the component (F). One of the first agent and the second agent contains the component (E).

The first agent contains at least one of the components (A) and (D), the component (E), and the component (F), and does not contain the component (B) and the component (C). On the other hand, more preferably, the second agent contains the component (B), the component (C), and the component (E), and does not contain the component (F).

Since the first agent having such a configuration contains (F) the platinum group metal-based curing catalyst, which accelerates the addition reaction, and does not contain the organo-hydrogen polysiloxane, progress of the addition reaction before the second agent is mixed can be prevented. Since the second agent contains the organo-hydrogen polysiloxane and does not contain (F) the platinum group metal-based curing catalyst, which accelerates the addition reaction, progress of the addition reaction before the first agent is mixed can be prevented.

All of the alkenyl group-containing organopolysiloxanes for constituting the thermally conductive composition may be contained in the first agent. Preferably, part of the alkenyl group-containing organopolysiloxanes is contained in the first agent, and the remainder thereof is contained in the second agent. More specifically, all of the components (A) and (D) for the thermally conductive composition may be contained in the first agent. Preferably, part of the components (A) and (D) is contained in the first agent, and the remainder of the components (A) and (D) is contained in the second agent.

When the alkenyl group-containing organopolysiloxanes are divided and contained in the first agent and the second agent as above, the first agent and the second agent are each readily controlled to have a viscosity in a desired range, and the mass ratio between the first agent and the second agent is also readily controlled to 1 or a value close to 1. Since the second agent also contains the organo-hydrogen polysiloxanes but does not contain (F) the platinum group metal-based curing catalyst, such a second agent can substantially inhibit progression of the addition reaction for example during storage even if the second agent contains the alkenyl group-containing organopolysiloxane. The second agent can contain a reaction controller to prevent progression of a reaction in the second agent.

When the alkenyl group-containing organopolysiloxane is contained in the second agent, a mixture thereof with the organo-hydrogen polysiloxanes may be incorporated in the second agent. For example, the component (A) may be mixed with the component (C), and the mixture may be incorporated into the second agent.

All of the organo-hydrogen polysiloxanes for constituting the thermally conductive composition are contained in the second agent, but not contained in the first agent.

(E) the thermally conductive filler may be contained one of the first agent and the second agent for forming the thermally conductive composition. However, as described above, (E) the thermally conductive filler is preferably contained in both of the first agent and the second agent, and more preferably, (E) the thermally conductive filler is substantially equally contained in these agents. Specifically, the ratio (mass ratio) of the content of (E) the thermally conductive filler in

the second agent to the content of (E) the thermally conductive filler in the first agent is preferably 0.67 to 1.5, more preferably 0.83 to 1.2, still more preferably 0.91 to 1.1. By substantially equally distributing (E) the thermally conductive filler to the first agent and the second agent, the difference in viscosity between the first agent and the second agent is readily reduced, and the mass ratio of the first agent to the second agent is also readily controlled to or around 1.

The thermally conductive composition preferably contains the component (G), and the component (G) may be contained in at least one of the first agent and the second agent. The component (G) is preferably contained in at least the first agent, more preferably contained in both of the first agent and the second agent. By containing the component (G) in both of the first agent and the second agent, the viscosities of the first agent and the second agent can be controlled by the component (G), and both of the first agent and the second agent can be each controlled to have a relatively low viscosity. When the component (G) contains the component (G-2), it is effective and preferred that the component (G-2) is contained in both of the first agent and the second agent.

<Viscosity>

The viscosity VB at 25°C of the binder resin contained in the thermally conductive composition is not particularly limited, and is preferably 50 to 800 mPa·s, more preferably 80 to 600 mPa·s, still more preferably 100 to 400 mPa·s.The viscosity VB of the binder resin indicates the viscosity of the organopolysiloxane contained in the thermally conductive composition, and is usually the viscosity of a mixture of the components (A) to (D) or the components (A) to (D) and (G). When an organopolysiloxane other than these is contained, the viscosity VB indicates the viscosity of a mixture further containing the other organopolysiloxane. The viscosities VB1 and VB2 of the binder resins in the first agent and the second agent described later also indicate the viscosities of the organopolysiloxanes contained in the first agent and the second agent, respectively.

In the two-pack type thermally conductive composition, the viscosities VB1 and VB2 at 25°C of the binder resins in the first agent and the second agent are each preferably 50 to 800 mPa·s, more preferably 80 to 600 mPa·s, still more preferably 100 to 400 mPa·s.

The viscosities VB1 and VB2 of the binder resins in the first agent and the second agent can be measured by mixing the organopolysiloxanes contained in each of the first agent and the second agent, and measuring the viscosity of the resulting organopolysiloxanes. The viscosity VB of the binder resin in the thermally conductive composition can also be measured in the same manner as above. For the two-pack type thermally conductive composition, an approximate viscosity VB can be estimated from the viscosities VB1 and VB2 of the binder resins in the first agent and the second agent, respectively.

In the two-pack type thermally conductive composition, the viscosities V1 and V2 of the first agent and the second agent, respectively, at a temperature of 25°C and a shear rate of 3.16 (1/s) are preferably 10 to 1000 Pa·s, more preferably 50 to 700 Pa·s, still more preferably 200 to 450 Pa·s. The first agent and the second agent each having the viscosity described above facilitate an improvement in handling properties.

The viscosity V of the thermally conductive composition according to the present invention at a temperature of 25°C and a shear rate of 3.16 (1/s) is preferably 10 to 1000 Pa·s or less, more preferably 50 to 700 Pa·s or less, still more preferably 200 to 450 Pa·s or less. The thermally conductive composition having such a viscosity has predetermined fluidity before curing, and can be applied to narrow gaps and complex shapes.

For the two-pack type thermally conductive composition, the viscosity V can be determined by mixing the first agent and the second agent, and immediately measuring the viscosity. Alternatively, an approximate viscosity can be estimated from the viscosities V1 and V2 of the first agent and the second agent.

In view of facilitating homogenous mixing of the thermally conductive composition, the difference between the viscosity V1 of the first agent and the viscosity V2 of the second agent (|V1-V2|) is preferably small. Specifically, the difference in viscosity between the first agent and the second agent (|V1-V2|) can be 130 Pa·s or less, for example. The difference is preferably 100 Pa·s or less, more preferably 30 Pa·s or less. The difference in viscosity between the first agent and the second agent (|V1-V2|) can be 0 Pa·s or more.

[Thermally conductive member]

Preferably, the thermally conductive composition according to the present invention is used in the form of a thermally conductive member such as a heat-dissipating gap filler. The thermally conductive member is a cured product formed by curing the thermally conductive composition.

The thermally conductive member is used inside an electronic device or the like. Specifically, the thermally conductive member is interposed between a heating element and a heat-dissipating element to conduct heat generated in the heating element to the heat-dissipating element by heat conduction and dissipate the heat from the heat-dissipating element. Here, examples of the heating element include a variety of electronic parts such as CPUs, power amplifiers, and power supplies used inside electronic devices. Examples of the heat-dissipating element include heat sinks, heat pumps,

and metal housings for electronic devices.

The thermally conductive member is preferably used in electrical component, for example. In the electrical component, the heating element is preferably disposed inside the engine room or near the motor. The present invention is particularly suitable for use as electrical component exposed to a high temperature environment at 150°C or more. The present invention is also suitable for dissipation of heat from the heating element which generates heat of 150°C or more.

The thermally conductive member can be formed, for example, by filling the thermally conductive composition into gaps between the heating element and the heat-dissipating element, and curing the composition. The curing may be performed by heating, and preferably, the curing is performed near normal temperature (e.g., about 0 to 40°C, preferably about 15 to 35°C). By curing the composition near normal temperature, the thermally conductive member can be disposed inside the electronic device without adding a thermal history to the electronic parts. When the thermally conductive composition is of a two-pack type, it is preferable that after mixing the first agent and the second agent, the mixture should be filled into gaps between the heating element and the heat-dissipating element, followed by curing.

The thermally conductive member can have any shape, may have a sheet shape, or may be used in another shape. The thermally conductive member can have any thickness, and may gave a thickness of, for example, 0.3 to 5 mm, preferably 0.5 to 4 mm, when used. The thermally conductive member according to the present invention, which has flexibility, can exhibit buffer properties, and can be thus suitably used under an environment where vibration occurs, when the thermally conductive member has a large thickness (e.g., 0.5 mm or more).

## Examples

Hereinafter, the present invention will be described in more detail by way of Examples, but the present invention is not limited at all by these examples.

### [Raman spectroscopy]

For each of the first agent and the second agent, liquid components were separated from solid components (thermally conductive filler) using a centrifuge. Then, Raman spectra of these separated liquid components were obtained. The Raman spectra were obtained under the following conditions.

apparatus: inVia Raman microscope QONTOR available from RENISHAW
spectrum range: 300 to 2500 $cm^{-1}$
wavelength of laser light: 532 nm, 100 mW (reduced to 10%)
grating: 1800 lines/mm
irradiation time: 1.0 s
integration: 100
object lens: x50

The Raman intensity ratio p2/p1 was estimated from the Raman intensity p2 at a wave number of 2130 $cm^{-1}$ and the Raman intensity p1 at a wave number of 2160 $cm^{-1}$ in the Raman spectroscopy spectrum obtained from the second agent containing the hydrosilyl group.

The Raman intensity ratio H/Vi (ratio of the intensity of the peak assigned to the hydrosilyl group to the intensity of the peaks assigned to the alkenyl group and the methacryloyl group) was calculated as described below. Specifically, in the Raman spectrum of the first agent and the Raman spectrum of the second agent, the area C of the peak of Si-O-Si at a wave number of 490 $cm^{-1}$, the area D of the peak of the vinyl group at a wave number of 1600 $cm^{-1}$, the area E of the methacryloyl group at a wave number of 1640 $cm^{-1}$, and the area F of the peak of the hydrosilyl group at a wave number of 2130 to 2160 $cm^{-1}$ were first calculated. Next, the following calculations were performed on the basis of the area C, and errors of the intensity in the runs were corrected to normalize.

area D/area C = area proportion D1
area E/area C = area proportion E1
area F/area C = area proportion F1

Subsequently, values obtained by multiplying the area proportions D1 and E1 of the first agent by the mass proportion of the liquid components contained in the first agent, and values obtained by multiplying the area proportions D1, E1, and F1 of the second agent by the mass proportion of the liquid components contained in the second agent were added to estimate D1, E1, and F1 in the thermally conductive composition.

Then, as an index, the ratio of the hydrosilyl group to (vinyl group + methacryloyl group) was determined by calculation of the following expression. Since there is a difference in Raman scattering intensity between the vinyl group

and the methacryloyl group, calculation was performed by multiplying 0.5 as a correction coefficient.

$$\text{Raman intensity ratio H/Vi} = \text{area proportion F1}/[\text{area proportion D}+(\text{area proportion E1} \times 0.5)]$$

When the thermally conductive composition has an alkenyl group other than the vinyl group, the peak intensity assigned to the alkenyl group other than the vinyl group can be calculated as above, and the Raman intensity ratio H/Vi can be calculated.

[Viscosities of organopolysiloxanes and viscosity of binder resin]

The viscosities at 25°C of the organopolysiloxanes and the viscosities VB1 and VB2 of the binder resins contained in the first agent and the second agent were measured in the following manner.
Using a rheometer "MCR-302e" available from Anton Paar GmbH, the temperature of a sample was adjusted to 25°C with a peltier plate, and the viscosity was measured using a cone plate of ϕ50 mm with an angle of 1° while the shear rate was continuously varied in the range of the shear rate of 10 to 100 (1/sec). Here, the viscosity at a shear rate of 10 (1/s) is used as the value of the viscosity.

[Viscosities of first agent and second agent]

The viscosities V1 and V2 of the first agent and the second agent were measured by the following method.
Using a rheometer "MCR-302e" available from Anton Paar GmbH, the temperature of a sample was adjusted to 25°C with a peltier plate, and the viscosity was measured using a parallel plate of ϕ25 mm while the shear rate was continuously varied in the range of shear rates of 0.0001 to 100 (1/s). The viscosities at shear rates of 0.0001 (1/s), 3.16 (1/s), and 6.31 (1/s) are shown in the tables.

[Hardness of cured product of thermally conductive composition]

The first agent and the second agent were filled into a 50-cc two-pack parallel cartridge (1:1 mixing cartridge "CDA050-01-PP" available from MIXPAC), and were mixed using a static mixer (static mixer for mixing two packs "MA6.3-12S", the number of elements: 6.3 mm × 12, inner diameter of ejection port: 1.5 mm) to prepare a thermally conductive composition (mass ratio: 1:1). To the release-treated surface of a PET film that had undergone a releasing treatment ("SG2" available from PANAC CO., LTD.), the resulting thermally conductive composition was applied such that the sample had a thickness of 2 mm, and another PET film ("SG2" available from PANAC CO., LTD.) was placed on the sample such that the release-treated surface of the another PET film was in contact with the sample, and was fixed by pressing. The resulting sample was left to stand at a temperature of 25°C and a humidity of 50%RH for 24 hours, thus obtaining a sample 1A. The resulting sample 1A was punched out into five sheets of a 30-mm square. The sheets were layered, and on the resultant, the type E hardness was measured. The hardness was treated as hardness E1.
A sample 2A was prepared by the same method as above, placed into the inside of a thermostat set at 150°C, and left to stand inside the thermostat for 250 hours. The sample 2A after left to stand for 250 hours was taken out from the thermostat, and was cooled to 25°C. Then, the type E hardness of the sample 2A was measured, and was treated as hardness E2. A sample 2A-2 and a sample 3A were prepared by the same method as above except that the time for leaving the sample inside the thermostat was changed to 500 hours and 1000 hours, respectively, and type E hardness was measured for the sample 2A-2 and a sample 3A. The results were treated as hardness E2-2 and hardness E3, respectively. From the found hardnesses E1, E2, and E3, E2/E1 and the change in hardness (E3)-(E2-2) were also determined.
The type E hardness was measured with a type E durometer according to JIS K 6253.

[Heat resistance of cured product of thermally conductive composition]

The first agent and the second agent were filled into a 50-cc two-pack parallel cartridge (1:1 mixing cartridge "CDA050-01-PP" available from MIXPAC), and were mixed using a static mixer (static mixer for mixing two packs "MA6.3-12S", the number of elements: 6.3 mm × 12, inner diameter of ejection port: 1.5 mm) to prepare a thermally conductive composition (mass ratio: 1:1). To the release-treated surfaces of a PET films that had undergone a releasing treatment ("SG2" available from, PANAC CO., LTD.) subjected to a releasing treatment, the resulting thermally conductive composition was applied such that the sample had a thickness of 0.5, 1.0, or 1.5 mm, and another PET film ("SG2" available from, PANAC CO., LTD.) was placed on the samples such that the release-treated surface of the another PET film was in contact with the sample, and was fixed by pressing. The sample was left to stand at a temperature of 25°C and a humidity of 50%RH for 24 hours to prepare a sample 1B. The heat resistance (initial) of the resulting sample 1B was

measured using a measurement apparatus in accordance with ASTM D5470-06.

The sample 1B prepared by the same method as above, placed into the thermostat set at 150°C, and left to stand inside the thermostat for 250 hours. The sample 2B after left to stand for 250 hours was taken out from the thermostat, and was cooled to 25°C. The heat resistance (after heating) was measured by the same method as above.

[Long-term heat resistance test]

The first agent and the second agent were filled into a 50-cc two-pack parallel cartridge (1:1 mixing cartridge "CDA050-01-PP" available from MIXPAC), and were mixed using a static mixer (static mixer for mixing two packs "MA6.3-12S", the number of elements: 6.3 mm × 12, inner diameter of ejection port: 1.5 mm) to prepare a thermally conductive composition (mass ratio: 1:1). The resulting thermally conductive composition was sandwiched and fixed between the flat surface of a heat sink (heat sink including a plate of 60 mm × 60 mm with a thickness of 6 mmt and 16 projections having a height of 24 mm on one surface of the plate, material: aluminum) and the surface of a stand (40 mm × 40 mm, thickness: 10 mmt, material: copper) such that the thickness of the thermally conductive composition was 1 mm using a spacer. At this time, the size of the thermally conductive composition was 40 mm × 40 mm × 1 mmt. Next, the thermally conductive composition was left to stand at a temperature of 25°C and a humidity of 50%RH for 24 hours to be cured, thus preparing a test sample.

First, the initial heat resistance was evaluated on the sample above by the following method. A thermal insulation material (plate of 50 mm × 90 mm with a thickness of 15 mmt, having a concavity of 26 mm × 26 mm with a depth of 1.7 mm, material: HIPLA) was provided, and a heater (available from Kashima Co., Ltd., "SCPU25 × 25", size: 25 × 25 mm, voltage and electricity: 100 V, 100 W) was set in the concavity, and the rear surface of the stand of the test sample was fixed thereon. At this time, to readily conduct the heat from the heater to the sample (stand), a thermally conductive grease of 3 W/m·K with a thickness of 50 μm was interposed between the surface of the heater and the rear surface of the stand. A thermocouple was inserted into insertion holes for the thermocouple positioned in the centers of the heat sink and the stand, and the distal end of the thermocouple was disposed above the center of the heater.

Subsequently, a cooling fan was disposed above the heat sink of the test sample, and the heat sink was blown by air at an air rate of 0.53 $m^3$/min and an air pressure of 49 Pa. Then, the resistance of the heater before heating was checked. Subsequently, the voltage was adjusted such that the electricity of the heater was 100 W. The temperature measured with the thermocouple on the heat sink side was designated as T1 and the temperature measured on the stand side was designated as T2. From the difference between T1 and T2 and the heating electricity of the heater, both after 10 minutes from the start of heating with the heater, heat resistance R1 (heat resistance = (T1-T2)/100) of the sample before the heat resistance test was calculated. Subsequently, the voltage of the heater was controlled to 0, and the heating was stopped. Thereafter, the test sample was cooled to room temperature, and was removed from the thermal insulation material, followed by a heat cycle test. The heat cycle test was performed for 1000 hours, in which one cycle was defined as an operation to leave the sample at -40°C for 30 minutes, heat the sample to 150°C, and then leave the sample for 30 minutes. Then, after 1000 hours, the test sample was taken out from the thermostat, and was left until the test sample spontaneously reached room temperature. Then, the heat resistance R2 after the heat cycle test was calculated in the same manner as above.

Then, the change from the initial heat resistance R1 to the heat resistance R2 after the heat cycle test determined above, (R2-R1)/R1 × 100(%), was calculated, and the degree of reduction of the heat resistance was evaluated according to the criteria below:

A: (R2-R1)/R1 × 100 is 10% or less, and the reliability is favorable.
B: (R2-R1)/R1 × 100 is more than 10% and 20% or less, and the reliability is practically acceptable.
C: (R2-R1)/R1 × 100 is more than 20%, and the reliability is not favorable.
D: The sample is not cured, and cannot be evaluated.

Materials below were used in Examples and Comparative Examples.

<Organopolysiloxanes>

Organopolysiloxane 1 (component (A)): an organopolysiloxane having a vinyl group at both terminals of the chain (vinyl group content: 0.17 mmol/g, viscosity: 410 mPa·s)

Organopolysiloxane 2 (component (A) and component (C)): a mixture of an organopolysiloxane having a vinyl group at both terminals of the chain (component (A)) and an organopolysiloxane having three or more hydrosilyl groups (component (C)) (vinyl group content: 0.15 mmol/g, hydrosilyl group content: 0.19 mmol/g, viscosity: 336 mPa·s,

mass ratio (component (A):component (C) = 95:5)
Organopolysiloxane 3 (component (A)): an organopolysiloxane having a vinyl group at both terminals of the chain (vinyl group content: 0.136 mmol/g, viscosity: 1193 mPa·s)
Organopolysiloxane 4 (component (A) and component (C)): a mixture of an organopolysiloxane having a vinyl group at both terminals of the chain (component (A)) and an organopolysiloxane having three or more hydrosilyl groups (component (C)) (vinyl group content: 0.041 mmol/g, hydrosilyl group content: 0.06 mmol/g, viscosity: 1034 mPa·s, mass ratio (component (A):component (C) = 95:5)
Organopolysiloxane 5 (component (A)): an organopolysiloxane having a vinyl group at both terminals of the chain (vinyl group content: 0.69 mmol/g, viscosity: 1157 mPa·s)
(In the organopolysiloxanes 2 and 4, the component (A) does not have a hydrosilyl group, and the component (C) does not have a vinyl group (alkenyl group).)
Organopolysiloxane 6 (component (B)): an organopolysiloxane having a hydrosilyl group at both terminals of the chain (hydrosilyl group content: 1.3 mmol/g, viscosity: 10 mPa·s)
Organopolysiloxane 7 (component (B)): an organopolysiloxane having a hydrosilyl group at both terminals of the chain (hydrosilyl group content: 0.333 mmol/g, viscosity: 100 mPa·s)
Organopolysiloxane 8 (component (B)): an organopolysiloxane having a hydrosilyl group at both terminals of the chain (hydrosilyl group content: 0.329 mmol/g, viscosity: 128 mPa·s)
Organopolysiloxane 9 (component (B)): an organopolysiloxane having a hydrosilyl group at both terminals of the chain (hydrosilyl group content: 0.116 mmol/g, viscosity: 1111 mPa·s)
Organopolysiloxane 10 (component (D)): an organopolysiloxane having a methacryloyl group at one terminal of the chain (methacryloyl group content: 0.10 mmol/g, viscosity: 177 mPa·s)
Organopolysiloxane 11 (component (G-1)): dimethyl silicone oil not having any hydrosilylation addition reactive group (viscosity: 101 mPa·s)
Organopolysiloxane 12 (component (G-2)): an organopolysiloxane not having any hydrosilylation addition reactive group, and having a trialkoxysilyl group at terminals (viscosity: 26 mPa·s)

<Platinum group metal-based curing catalyst>

Platinum catalyst (component (F))

<Thermally conductive filler>

Aluminum oxide 1 (component (E)): spherical alumina (D50: 0.5 μm)
Aluminum oxide 2 (component (E)): spherical alumina (D50: 3 μm)
Aluminum oxide 3 (component (E)): spherical alumina (D50: 18 μm)
Aluminum oxide 4 (component (E)): spherical alumina (D50: 40 μm)
Aluminum oxide 5 (component (E)): spherical alumina (D50: 60 μm)

[Examples 1 to 12, Comparative Examples 1 to 7]

First agents and second agents were prepared according to the formulations shown in Tables 1 to 3 below. For thermally conductive compositions prepared by mixing the first agents and the corresponding second agents, a variety of physical properties were measured and evaluated.

[Table 1]

| | | Example 1 | | Example 2 | | Example 3 | | Example 4 | | Example 5 | | Example 6 | | Example 7 | |
|---|---|---|---|---|---|---|---|---|---|---|---|---|---|---|---|
| | | First agent | Second agent | First agent | Second agent | First agent | Second agent | First agent | Second agent | First agent | Second agent | First agent | Second agent | First agent | Second agent |
| Composition (parts by mass) | Organopolysiloxane 1 (A) | 51.1 | | 42.6 | | 42.6 | | 42.6 | | 42.6 | | 42.6 | | 42.6 | |
| | Organopolysiloxane 2 (A, C) | | 51.1 | | 42.6 | | 42.6 | | 42.6 | | 42.6 | | 42.6 | | 42.6 |
| | Organopolysiloxane 3 (A) | | | | | | | | | | | | | | |
| | Organopolysiloxane 4 (A, C) | | | | | | | | | | | | | | |
| | Organopolysiloxane 5 (A) | | | | | | | | | | | | | | |
| | Organopolysiloxane 6 (B) | | | | | | | | | | | | | | |
| | Organopolysiloxane 7 (B) | | 25.5 | | 25.5 | | 25.5 | | 25.5 | | 25.5 | | | | |
| | Organopolysiloxane 8 (B) | | | | | | | | | | | | 25.5 | | 25.5 |
| | Organopolysiloxane 9 (B) | | | | | | | | | | | | | | |
| | Organopolysiloxane 10 (D) | 25.5 | 8.5 | 17.0 | 17.0 | 17.0 | 17.0 | 17.0 | 17.0 | 17.0 | 17.0 | 17.0 | 17.0 | 17.0 | 17.0 |
| | Organopolysiloxane 11 (G) | 8.5 | | 25.5 | | 25.5 | | 25.5 | | 25.5 | | 25.5 | | 25.5 | |
| | Organopolysiloxane 12 (G) | 14.9 | 14.9 | 14.9 | 14.9 | 14.9 | 14.9 | 14.9 | 14.9 | 14.9 | 14.9 | 14.9 | 14.9 | 14.9 | 14.9 |
| | Platinum catalyst (F) | 0.17 | | 0.04 | | 0.09 | | 0.17 | | 0.26 | | 0.04 | | 0.17 | |
| | Aluminum oxide 1 (E) | 194 | 194 | 194 | 194 | 194 | 194 | 194 | 194 | 194 | 194 | 194 | 194 | 194 | 194 |
| | Aluminum oxide 2 (E) | 469 | 469 | 469 | 469 | 469 | 469 | 469 | 469 | 469 | 469 | 469 | 469 | 469 | 469 |
| | Aluminum oxide 3 (E) | 139 | 139 | 139 | 139 | 139 | 139 | 139 | 139 | 139 | 139 | 139 | 139 | 139 | 139 |
| | Aluminum oxide 4 (E) | 260 | 260 | 260 | 260 | 260 | 260 | 260 | 260 | 260 | 260 | 260 | 260 | 260 | 260 |
| | Aluminum oxide 5 (E) | 933 | 933 | 933 | 933 | 933 | 933 | 933 | 933 | 933 | 933 | 933 | 933 | 933 | 933 |
| | E) Total amount of thermally conductive filler | 1994 | 1994 | 1994 | 1994 | 1994 | 1994 | 1994 | 1994 | 1994 | 1994 | 1994 | 1994 | 1994 | 1994 |

(continued)

| | | | Example 1 | | Example 2 | | Example 3 | | Example 4 | | Example 5 | | Example 6 | | Example 7 | |
|---|---|---|---|---|---|---|---|---|---|---|---|---|---|---|---|---|
| | | | First agent | Second agent | First agent | Second agent | First agent | Second agent | First agent | Second agent | First agent | Second agent | First agent | Second agent | First agent | Second agent |
| Amount of functional group, content | Total Vi content 1 | mmol/g | 0.15 | 0.10 | 0.15 | 0.10 | 0.15 | 0.10 | 0.15 | 0.10 | 0.15 | 0.10 | 0.15 | 0.10 | 0.15 | 0.10 |
| | Total Vi content 2 | μmol/g | 4.7 | | 4.1 | | 4.1 | | 4.1 | | 4.1 | | 4.1 | | 4.1 | |
| | Hydrosilyl group content 1 | mmol/g | 0 | 0.22 | 0 | 0.20 | 0 | 0.20 | 0 | 0.20 | 0 | 0.20 | 0 | 0.20 | 0 | 0.20 |
| | Hydrosilyl group content 2 | μmol/g | 4.4 | | 4.0 | | 4.0 | | 4.0 | | 4.0 | | 4.0 | | 4.0 | |
| | Content ratio H/Vi | | 0.93 | | 0.98 | | 0.98 | | 0.98 | | 0.98 | | 0.98 | | 0.98 | |
| | Hydrosilyl group concentration ratio [b/(b+c)] | | 0.46 | | 0.51 | | 0.51 | | 0.51 | | 0.51 | | 0.51 | | 0.51 | |
| | DVi content /total Vi content | | 0.17 | | 0.20 | | 0.20 | | 0.20 | | 0.20 | | 0.20 | | 0.20 | |
| | Total content (% by mass) of component (G) (relative to total amount of organopolysiloxanes) | | 19% | | 28% | | 28% | | 28% | | 28% | | 28% | | 28% | |
| | Raman intensity ratio p2/p1 | | 3.20 | | 3.39 | | 3.39 | | 3.39 | | 3.39 | | 3.02 | | 3.02 | |
| | Raman intensity ratio H/Vi | | 9.10 | | 8.24 | | 8.24 | | 8.24 | | 8.24 | | 7.76 | | 7.76 | |

(continued)

| | | | Example 1 | | Example 2 | | Example 3 | | Example 4 | | Example 5 | | Example 6 | | Example 7 | |
|---|---|---|---|---|---|---|---|---|---|---|---|---|---|---|---|---|
| | | | First agent | Second agent | First agent | Second agent | First agent | Second agent | First agent | Second agent | First agent | Second agent | First agent | Second agent | First agent | Second agent |
| Viscosity | Viscosity of binder resin VB1, VB2 (mPa·s) | | 194 | 159 | 164 | 151 | 164 | 151 | 164 | 151 | 164 | 151 | 164 | 160 | 164 | 160 |
| | Viscosity of hermally conductive composition V1, V2 (Pa·s) | 0.00011/s | 66607 | 61839 | 66559 | 60700 | 66559 | 60700 | 66559 | 60700 | 66559 | 60700 | 62583 | 62024 | 62583 | 62024 |
| | | 3.16 1/s | 386 | 331 | 369 | 318 | 369 | 318 | 369 | 318 | 369 | 318 | 340 | 333 | 340 | 333 |
| | | 6.31 1/s | 316 | 274 | 316 | 263 | 316 | 263 | 316 | 263 | 316 | 263 | 280 | 275 | 280 | 275 |
| | Difference in viscosity between first agent and second agent (Pa·s) (3.16 1/s) | | 55 | | 51 | | 51 | | 51 | | 51 | | 6 | | 6 | |
| Physical properties of cured product | Hardness E after 24 hours at 25°C (E1) | | 37 | | 21 | | 24 | | 29 | | 33 | | 36 | | 41 | |
| | Hardness E after 250 hours at 150°C (E2 | | 69 | | 67 | | 67 | | 67 | | 68 | | 65 | | 69 | |
| | Hardness E after 500 hours at 150°C (E2-2) | | 73 | | 68 | | 68 | | 68 | | 70 | | 67 | | 70 | |
| | Hardness E after 1000 hours at 150°C (E3) | | 74 | | 69 | | 69 | | 69 | | 71 | | 68 | | 71 | |
| | Change in hardness [(E3)-(E2-2)] | | 1 | | 1 | | 1 | | 1 | | 1 | | 1 | | 4 | |
| | E2/E1 | | 1.9 | | 3.2 | | 2.8 | | 2.3 | | 2.1 | | 1.8 | | 1.7 | |
| Evaluations | Heat resistance initial (25°C, 24 hours) | | 1.07 | | 0.97 | | 1.00 | | 1.03 | | 1.04 | | 1.10 | | 1.09 | |
| | Heat resistance after heating (25°C, 24 hours + 150°C, 250 hours) | | 1.47 | | 1.39 | | 1.39 | | 1.39 | | 1.43 | | 1.33 | | 1.47 | |
| | Long-term heat resistance (150°C → reduction after 1000 hours) | | B | | A | | A | | A | | B | | A | | B | |

[Table 2]

| | | Example 8 | | Example 9 | | Example 10 | | Example 11 | | Example 12 | | Comparative Example 1 | | Comparative Example 2 | |
|---|---|---|---|---|---|---|---|---|---|---|---|---|---|---|---|
| | | First agent | Second agent | First agent | Second agent | First agent | Second agent | First agent | Second agent | First agent | Second agent | First agent | Second agent | First agent | Second agent |
| Composition (parts by mass) | Organopolysiloxane 1 (A) | 42.6 | | 38.3 | | 36.2 | | | | | | 59.6 | | 42.6 | |
| | Organopolysiloxane 2 (A, C) | | 42.6 | | 38.3 | | 36.2 | | | | | | 57.0 | | 42.6 |
| | Organopolysiloxane 3 (A) | | | | | | | 23.5 | | 34.0 | | | | | |
| | Organopolysiloxane 4 (A, C) | | | | | | | | 23.5 | | 17.0 | | | | |
| | Organopolysiloxane 5 (A) | | | | | | | 7.8 | | | | | | | |
| | Organopolysiloxane 6 (B) | | | | | | | | | | | | 2.6 | | |
| | Organopolysiloxane 7 (B) | | | | | | | | 3.9 | | 4.3 | | | | 17.0 |
| | Organopolysiloxane 8 (B) | | 25.5 | | 25.5 | | 25.5 | | | | | | | | |
| | Organopolysiloxane 9 (B) | | | | | | | | 19.6 | | 29.8 | | | | |
| | Organopolysiloxane 10 (D) | 17.0 | 17.0 | 17.0 | 17.0 | 17.0 | 17.0 | 3.9 | | 4.3 | | | | | |
| | Organopolysiloxane 11 (G) | 25.5 | | 29.8 | 4.3 | 31.9 | 6.4 | 47.1 | 51.0 | 46.8 | 34.0 | 25.5 | 25.5 | 42.6 | 25.5 |
| | Organopolysiloxane 12 (G) | 14.9 | 14.9 | 14.9 | 14.9 | 14.9 | 14.9 | 9.8 | 9.8 | 14.9 | 14.9 | 14.9 | 14.9 | 14.9 | 14.9 |
| | Platinum catalyst (F) | 0.26 | | 0.09 | | 0.09 | | 0.24 | | 0.26 | | 0.68 | | 0.68 | |
| | Aluminum oxide 1 (E) | 194 | 194 | 194 | 194 | 194 | 194 | 179 | 179 | 194 | 194 | 194 | 194 | 194 | 194 |
| | Aluminum oxide 2 (E) | 469 | 469 | 469 | 469 | 469 | 469 | 432 | 432 | 469 | 469 | 469 | 469 | 469 | 469 |
| | Aluminum oxide 3 (E) | 139 | 139 | 139 | 139 | 139 | 139 | 128 | 128 | 139 | 139 | 139 | 139 | 139 | 139 |
| | Aluminum oxide 4 (E) | 260 | 260 | 260 | 260 | 260 | 260 | 239 | 239 | 260 | 260 | 260 | 260 | 260 | 260 |
| | Aluminum oxide 5 (E) | 933 | 933 | 933 | 933 | 933 | 933 | 860 | 860 | 933 | 933 | 933 | 933 | 933 | 933 |
| | (E) Total amount of thermally conductive filler | 1994 | 1994 | 1994 | 1994 | 1994 | 1994 | 1838 | 1838 | 1994 | 1994 | 1994 | 1994 | 1994 | 1994 |

(continued)

| | | | Example 8 | | Example 9 | | Example 10 | | Example 11 | | Example 12 | | Comparative Example 1 | | Comparative Example 2 | |
|---|---|---|---|---|---|---|---|---|---|---|---|---|---|---|---|---|
| | | | First agent | Second agent | First agent | Second agent | First agent | Second agent | First agent | Second agent | First agent | Second agent | First agent | Second agent | First agent | Second agent |
| Amount of functional group, content | Total Vi content 1 | mmol/g | 0.15 | 0.10 | 0.15 | 0.09 | 0.15 | 0.09 | 0.12 | 0.02 | 0.13 | 0.01 | 0.17 | 0.14 | 0.17 | 0.11 |
| | Total Vi content 2 | μmol/g | 4.1 | | 3.7 | | 3.6 | | 1.3 | | 1.4 | | 4.5 | | 3.3 | |
| | Hydrosilyl group content 1 | mmol/g | 0 | 0.20 | 0 | 0.20 | 0 | 0.20 | 0 | 0.11 | 0 | 0.12 | 0 | 0.24 | 0 | 0.23 |
| | Hydrosilyl group content 2 | μmol/g | 4.0 | | 3.8 | | 3.7 | | 1.3 | | 1.4 | | 3.4 | | 3.3 | |
| | Content ratio H/Vi | | 0.98 | | 1.01 | | 1.03 | | 0.98 | | 1.02 | | 0.77 | | 1.02 | |
| | Hydrosilyl group concentration ratio [b/(b+c)] | | 0.51 | | 0.53 | | 0.55 | | 0.72 | | 0.83 | | 0.23 | | 0.41 | |
| | DVi content /total Vi content | | 0.20 | | 0.22 | | 0.23 | | 0.08 | | 0.07 | | 0 | | 0 | |
| | Total content (% by mass) of component (G) (relative to total amount of organopolysiloxanes) | | 28% | | 32% | | 34% | | 59% | | 55% | | 40% | | 49% | |
| | Raman intensity ratio p2/p1 | | 3.02 | | 3.35 | | 3.67 | | 5.49 | | 4.30 | | 2.61 | | 2.96 | |
| | Raman intensity ratio H/Vi | | 7.76 | | 8.76 | | 8.24 | | 13.43 | | 10.34 | | 6.79 | | 9.10 | |

(continued)

| | | | Example 8 | | Example 9 | | Example 10 | | Example 11 | | Example 12 | | Comparative Example 1 | | Comparative Example 2 | |
|---|---|---|---|---|---|---|---|---|---|---|---|---|---|---|---|---|
| | | | First agent | Second agent | First agent | Second agent | First agent | Second agent | First agent | Second agent | First agent | Second agent | First agent | Second agent | First agent | Second agent |
| Viscosity | Viscosity of binder resin VB1, VB2 (mPa·s) | | 164 | 160 | 155 | 152 | 150 | 149 | 252 | 234 | 238 | 250 | 190 | 152 | 150 | 137 |
| | Viscosity of thermally conductive composition V1, V2 (Pa·s) | 0.0001 1/s | 62583 | 62024 | 61300 | 60947 | 60687 | 60429 | 151570 | 94361 | 37600 | 42142 | 20795 | 45054 | 60571 | 58879 |
| | | 3.16 1/s | 340 | 333 | 325 | 321 | 318 | 315 | 395 | 422 | 454 | 563 | 423 | 468 | 394 | 297 |
| | | 6.31 1/s | 280 | 275 | 269 | 266 | 263 | 261 | 314 | 338 | 370 | 469 | 339 | 368 | 321 | 247 |
| | Difference in viscosity between first agent and second agent (Pa·s) (3.16 1/s) | | 6 | | 4 | | 3 | | 27 | | 109 | | 45 | | 97 | |
| Physical properties of cured product | Hardness E after 24 hours at 25°C (E1) | | 46 | | 22 | | 21 | | 40 | | 18 | | 32 | | 68 | |
| | Hardness E after 250 hours at 150°C (E2 | | 69 | | 63 | | 61 | | 57 | | 56 | | 77 | | 76 | |
| | Hardness E after 500 hours at 150°C (E2-2) | | 70 | | 64 | | 62 | | 63 | | 58 | | 78 | | 78 | |
| | Hardness E after 1000 hours at 150°C (E3) | | 72 | | 65 | | 63 | | 66 | | 63 | | 85 | | 86 | |
| | Change in hardness [(E3)-(E2-2)] | | 2 | | 1 | | 1 | | 3 | | 5 | | 7 | | 8 | |
| | E2/E1 | | 1.5 | | 2.9 | | 3.0 | | 1.4 | | 3.1 | | 2.4 | | 1.1 | |
| Evaluations | Heat resistance, initial (25°C, 24 hours) | | 1.11 | | 0.96 | | 0.98 | | 1.05 | | 0.99 | | 1.01 | | 1.43 | |
| | Heat resistance after heating (25°C, 24 hours + 150°C, 250 hours) | | 1.47 | | 1.28 | | 1.19 | | 1.21 | | 1.13 | | 1.75 | | 1.72 | |
| | Long-term heat resistance (150°C → reduction after 1000 hours) | | B | | A | | A | | B | | A | | C | | C | |

[Table 3]

| | | Comparative Example 3 | | Comparative Example 4 | | Comparative Example 5 | | Comparative Example 6 | | Comparative Example 7 | |
|---|---|---|---|---|---|---|---|---|---|---|---|
| | | First agent | Second agent | First agent | Second agent | First agent | Second agent | First agent | Second agent | First agent | Second agent |
| Composition (parts by mass) | Organopolysiloxane 1 (A) | 51.1 | | 59.6 | | 42.6 | | 42.6 | | | |
| | Organopolysiloxane 2 (A, C) | | 51.1 | | 59.6 | | 42.6 | | 42.6 | | |
| | Organopolysiloxane 3 (A) | | | | | | | | | 34.0 | |
| | Organopolysiloxane 4 (A, C) | | | | | | | | | | 34.0 |
| | Organopolysiloxane 5 (A) | | | | | | | | | | |
| | Organopolysiloxane 6 (B) | | | | | | | | | | |
| | Organopolysiloxane 7 (B) | | 19.6 | | 23.0 | | 4.3 | | 8.5 | | 51.1 |
| | Organopolysiloxane 8 (B) | | | | | | | | | | |
| | Organopolysiloxane 9 (B) | | | | | | 29.8 | | 25.5 | | |
| | Organopolysiloxane 10 (D) | | | | | | | | | | |
| | Organopolysiloxane 11 (G) | 34.0 | 14.5 | 25.5 | 2.6 | 42.6 | 8.5 | 42.6 | 8.5 | 42.6 | |
| | Organopolysiloxane 12 (G) | 14.9 | 14.9 | 14.9 | 14.9 | 14.9 | 14.9 | 14.9 | 14.9 | 14.9 | 14.9 |
| | Platinum catalyst (F) | 0.68 | | 0.68 | | 0.68 | | 0.68 | | 0.17 | |
| | Aluminum oxide 1 (E) | 194 | 194 | 194 | 194 | 194 | 194 | 194 | 194 | 194 | 194 |
| | Aluminum oxide 2 (E) | 469 | 469 | 469 | 469 | 469 | 469 | 469 | 469 | 469 | 469 |
| | Aluminum oxide 3 (E) | 139 | 139 | 139 | 139 | 139 | 139 | 139 | 139 | 139 | 139 |
| | Aluminum oxide 4 (E) | 260 | 260 | 260 | 260 | 260 | 260 | 260 | 260 | 260 | 260 |
| | Aluminum oxide 5 (E) | 933 | 933 | 933 | 933 | 933 | 933 | 933 | 933 | 933 | 933 |
| | (E) Total amount of thermally conductive filler | 1994 | 1994 | 1994 | 1994 | 1994 | 1994 | 1994 | 1994 | 1994 | 1994 |

(continued)

| | | | Comparative Example 3 | | Comparative Example 4 | | Comparative Example 5 | | Comparative Example 6 | | Comparative Example 7 | |
|---|---|---|---|---|---|---|---|---|---|---|---|---|
| | | | First agent | Second agent | First agent | Second agent | First agent | Second agent | First agent | Second agent | First agent | Second agent |
| Amount of functional group, content | Total Vi content 1 | mmol/g | 0.17 | 0.11 | 0.17 | 0.11 | 0.17 | 0.08 | 0.17 | 0.08 | 0.14 | 0.02 |
| | Total Vi content 2 | μmol/g | 3.9 | | 4.6 | | 3.3 | | 3.3 | | 1.4 | |
| | Hydrosilyl group content 1 | mmol/g | 0 | 0.23 | 0 | 0.23 | 0 | 0.17 | 0 | 0.18 | 0 | 0.22 |
| | Hydrosilyl group content 2 | μmol/g | 3.9 | | 4.6 | | 3.1 | | 3.3 | | 4.6 | |
| | Content ratio H/Vi | | 1.00 | | 1.00 | | 0.96 | | 1.03 | | 3.16 | |
| | Hydrosilyl group concentration ratio [b/(b+c)] | | 0.40 | | 0.40 | | 0.37 | | 0.41 | | 0.89 | |
| | DVi content /total Vi content | | 0 | | 0 | | 0 | | 0 | | 0.00 | |
| | Total content (% by mass) of component (G) (relative to total amount of organopolysiloxanes) | | 39% | | 29% | | 40% | | 40% | | 38% | |
| | Raman intensity ratio p2/p1 | | 2.91 | | 2.79 | | 2.75 | | 2.77 | | 4.91 | |
| | Raman intensity ratio H/Vi | | 8.72 | | 8.72 | | 8.21 | | 8.82 | | 38.58 | |
| Viscosity | Viscosity of binder resin VB1, VB2 (mPa·s) | | 198 | 152 | 190 | 168 | 150 | 280 | 150 | 253 | 205 | 181 |
| | Viscosity of thermally conductive composition V1, V2 (Pa·s) | 0.0001 1/s | 64101 | 60860 | 41002 | 63049 | 59618 | 78233 | 57199 | 74543 | 67440 | 64784 |
| | | 3.16 1/s | 429 | 320 | 503 | 345 | 419 | 520 | 436 | 478 | 396 | 365 |
| | | 6.31 1/s | 335 | 265 | 412 | 285 | 326 | 421 | 353 | 388 | 324 | 300 |
| | Difference in viscosity between first agent and second agent (Pa·s) (3.16 1/s) | | 109 | | 158 | | 101 | | 42 | | 31 | |
| Physical properties of cured product | Hardness E after 24 hours at 25°C (E1) | | 71 | | 70 | | 60 | | 71 | | Not cured | |
| | Hardness E after 250 hours at 150°C (E2) | | 80 | | 76 | | 76 | | 76 | | - | |
| | Hardness E after 500 hours at 150°C (E2-2) | | 82 | | 78 | | 78 | | 78 | | - | |
| | Hardness E after 1000 hours at 150°C (E3) | | 85 | | 83 | | 80 | | 80 | | - | |
| | Change in hardness [(E3)-(E2-2)] | | 3 | | 5 | | 2 | | 2 | | - | |
| | E2/E1 | | 1.1 | | 1.1 | | 1.3 | | 1.1 | | - | |

(continued)

| | | Comparative Example 3 | | Comparative Example 4 | | Comparative Example 5 | | Comparative Example 6 | | Comparative Example 7 | |
|---|---|---|---|---|---|---|---|---|---|---|---|
| | | First agent | Second agent | First agent | Second agent | First agent | Second agent | First agent | Second agent | First agent | Second agent |
| Evaluations | Heat resistance, initial (25°C, 24 hours) | 1.51 | | 1.50 | | 1.18 | | 1.52 | | - | |
| | Heat resistance after heating (25°C, 24 hours + 150°C, 250 hours) | 1.85 | | 1.72 | | 1.72 | | 1.72 | | - | |
| | Long-term heat resistance (150°C → reduction after 1000 hours) | C | | C | | C | | C | | D | |

* The total Vi content 1 indicates the total content of the alkenyl group and the methacryloyl group relative to the total amount of the organopolysiloxanes 1 to 10 in the first agent and the second agent.
* The total Vi content 2 indicates the total content of the vinyl group and the methacryloyl group relative to the total amount of the thermally conductive composition (the first agent and the second agent).
* The hydrosilyl group content 1 indicates the content of the hydrosilyl group relative to the total amount of the organopolysiloxanes 1 to 10.
* The hydrosilyl group content 2 indicates the content of the hydrosilyl group relative to the total amount of the thermally conductive composition (the first agent and the second agent).

In the thermally conductive compositions in Examples 1 to 12 above, the components (A) to (F) were contained, the Raman intensity ratio p2/p1 was larger than 3.00, and the component (B) and the component (C) were contained such that the hydrosilyl group concentration ratio b/(b+c) was larger than 0.45. The type E hardness (E2) after these compositions were left to stand at 25°C for 24 hours and further at 150°C for 250 hours was less than 70. Thus, cured products of these thermally conductive compositions maintained favorable flexibility even under an environment at 150°C, and had favorable reliability. Hence, even when the cured products of the thermally conductive compositions were used as thermally conductive members under a high temperature environment, peel off of the cured products from the heating element and/or the heat sink was prevented, and an increase in heat resistance was thus suppressed.

In contrast, in the thermally conductive compositions in Comparative Examples 1 to 7, the component (D) was not contained, or the Raman intensity ratio p2/p1 was 3.00 or less, and the component (B) and the component (C) were contained such that the hydrosilyl group concentration ratio b/(b+c) was not more than 0.45. For this reason, in Comparative Examples 1 to 6, the cured products thereof did not maintain favorable flexibility under an environment at 150°C or more, and did not have favorable reliability. Hence, when the cured products of the thermally conductive compositions were used as thermally conductive members under an environment at 150°C or more, peel off thereof from the heating element and/or the heat sink occurred, and an increase in heat resistance was not suppressed. In Comparative Example 7, curing failure occurred.

## Claims

**1.** A thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and
(F) a platinum group metal-based curing catalyst,
the Raman intensity p1 at 2160 $cm^{-1}$ and the Raman intensity p2 at 2130 $cm^{-1}$ in a Raman spectroscopy spectrum satisfying the relation represented by Expression (1-1) below, and
a type E hardness E2 after the composition is left to stand at 25°C for 24 hours and further at 150°C for 250 hours satisfying Expression (2) below:

$$p2/p1>3.00 \quad ...(1\text{-}1)$$

$$E2<70 \qquad ...(2).$$

**2.** A thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and
(F) a platinum group metal-based curing catalyst,
the components (B) and (C) being contained to satisfy the relation represented by Expression (1-2) below, and
a type E hardness E2 after the composition is left to stand at 25°C for 24 hours and further at 150°C for 250 hours satisfying Expression (2) below:

$$b/(b+c)>0.45 \quad ...(1\text{-}2)$$

(In Expression (1-2), b represents the concentration of the hydrosilyl group contained in the component (B), and c represents the concentration of the hydrosilyl group contained in the component (C).)

$$E2<70 \qquad ...(2).$$

**3.** A thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and
(F) a platinum group metal-based curing catalyst,

the composition being a combination of: a first agent containing at least one of the components (A) and (D); and the component (F) but not containing the component (B) and the component (C); and a second agent containing the component (B) and the component (C) but not containing the component (F),

the Raman intensity p1 at 2160 $cm^{-1}$ and the Raman intensity p2 at 2130 $cm^{-1}$ in a Raman spectroscopy spectrum satisfying the relation represented by Expression (1-1) below, and
a type E hardness E2 after the first agent and the second agent are mixed, and then are left to stand at 25°C for 24 hours and further at 150°C for 250 hours satisfying Expression (2) below:

$$p2/p1>3.00 \quad ...(1\text{-}1)$$

$$E2<70 \quad ...(2).$$

**4.** A thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and
(F) a platinum group metal-based curing catalyst,

the composition being a combination of: a first agent containing at least one of the components (A) and (D); and the component (F) but not containing the component (B) and the component (C); and a second agent containing the component (B) and the component (C) but not containing the component (F),

the components (B) and (C) being contained to satisfy the relation represented by Expression (1-2) below, and
a type E hardness E2 after the first agent and the second agent are mixed, and then are left to stand at 25°C for 24 hours and further at 150°C for 250 hours satisfying Expression (2) below:

$$b/(b+c)>0.45 \quad ...(1\text{-}2)$$

(In Expression (1-2), b represents the concentration of the hydrosilyl group contained in the component (B), and c represents the concentration of the hydrosilyl group contained in the component (C).)

$$E2<70 \quad ...(2).$$

**5.** The thermally conductive composition according to any one of claims 1 to 4, further comprising: (G) an organopolysiloxane having no addition reactive group.

**6.** The thermally conductive composition according to claim 5, wherein the component (G) contains: (G-2) an organopolysiloxane having at least one alkoxy group.

**7.** The thermally conductive composition according to any one of claims 1 to 6, wherein a type E hardness E1 after the composition is left to stand at 25°C for 24 hours and the type E hardness E2 satisfy the relation represented by Expression (3) below:

$$1.4 \leq E2/E1 \leq 3.5 \quad ...(3).$$

**8.** The thermally conductive composition according to any one of claims 1 to 7, wherein the component (D) is an organopolysiloxane having one methacryloyl group.

**9.** The thermally conductive composition according to any one of claims 1 to 8, wherein the total content of the alkenyl group and the methacryloyl group is 5.0 μmol/g or less.

**10.** The thermally conductive composition according to any one of claims 1 to 9, wherein the content of the hydrosilyl group, H, and the total content of the alkenyl group and the methacryloyl group, Vi, satisfy the relation represented by Expression (4) below:

$$0.85 \leq H/Vi \leq 1.1 \quad ....(4).$$

**11.** A thermally conductive member which is a cured product of the thermally conductive composition according to any one of claims 1 to 10.

**12.** A first agent usable as a thermally conductive composition by mixing with a second agent, the thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and
(F) a platinum group metal-based curing catalyst,
the first agent containing at least one of the components (A) and (D); and the component (F) but not containing the component (B) and the component (C),
the Raman intensity p1 at 2160 $cm^{-1}$ and the Raman intensity p2 at 2130 $cm^{-1}$ in a Raman spectroscopy spectrum satisfying the relation represented by Expression (1-1) below in a case where the first agent is combined with the second agent, and
a type E hardness E2 after the first agent and the second agent are mixed, and then are left to stand at 25°C for 24 hours and further at 150°C for 250 hours satisfying Expression (2) below:

$$p2/p1 > 3.00 \quad ...(1\text{-}1)$$

$$E2 < 70 \quad ...(2).$$

**13.** A second agent usable as a thermally conductive composition by mixing with a first agent, the thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and
(F) a platinum group metal-based curing catalyst,
the second agent containing the component (B) and the component (C) but not containing the component (F),
the Raman intensity p1 at 2160 $cm^{-1}$ and the Raman intensity p2 at 2130 $cm^{-1}$ in a Raman spectroscopy spectrum satisfying in a case where the second agent is combined with the first agent, the relation represented by Expression (1-1) below, and
a type E hardness E2 after the first agent and the second agent are mixed, and then are left to stand at 25°C for 24 hours and further at 150°C for 250 hours satisfying Expression (2) below:

$$p2/p1>3.00 \quad ...(1\text{-}1)$$

$$E2<70 \qquad ...(2)$$

**14.** A first agent usable as a thermally conductive composition by mixing with a second agent, the thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and
(F) a platinum group metal-based curing catalyst,
the first agent containing at least one of the components (A) and (D); and the component (F) but not containing the component (B) or the component (C),
the thermally conductive composition containing the components (B) and (C) to satisfy the relation represented by Expression (1-2) below, and
a type E hardness E2 after the first agent and the second agent are mixed, and then are left to stand at 25°C for 24 hours and further at 150°C for 250 hours satisfying Expression (2) below:

$$b/(b+c)>0.45 \quad ...(1\text{-}2)$$

(In Expression (1-2), b represents the concentration of the hydrosilyl group contained in the component (B), and c represents the concentration of the hydrosilyl group contained in the component (C).)

$$E2<70 \qquad ...(2).$$

**15.** A second agent usable as a thermally conductive composition by mixing with a first agent, the thermally conductive composition comprising:

(A) an organopolysiloxane having two or more alkenyl groups;
(B) an organo-hydrogen polysiloxane having two hydrosilyl groups;
(C) an organo-hydrogen polysiloxane having three or more hydrosilyl groups;
(D) an organopolysiloxane having one alkenyl or methacryloyl group;
(E) a thermally conductive filler; and
(F) a platinum group metal-based curing catalyst,
the second agent containing the component (B) and the component (C) but not containing the component (F),
the components (B) and (C) being contained to satisfy the relation represented by Expression (1-2) below, and
a type E hardness E2 after the first agent and the second agent are mixed, and then are left to stand at 25°C for 24 hours and further at 150°C for 250 hours satisfying Expression (2) below:

$$b/(b+c)>0.45 \quad ...(1\text{-}2)$$

(In Expression (1-2), b represents the concentration of the hydrosilyl group contained in the component (B), and c represents the concentration of the hydrosilyl group contained in the component (C).)

$$E2<70 \qquad ...(2).$$

## INTERNATIONAL SEARCH REPORT

International application No. **PCT/JP2023/022402**

**A. CLASSIFICATION OF SUBJECT MATTER**

***C09K 5/14***(2006.01)i; ***C08L 83/04***(2006.01)i; ***C08L 83/05***(2006.01)i; ***C08L 83/07***(2006.01)i
FI: C09K5/14 E; C08L83/04; C08L83/05; C08L83/07

According to International Patent Classification (IPC) or to both national classification and IPC

**B. FIELDS SEARCHED**

Minimum documentation searched (classification system followed by classification symbols)

C09K5/00-5/20; C08K3/00-13/08; C08L1/00-101/14

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2022/075434 A1 (DOW TORAY CO., LTD.) 14 April 2022 (2022-04-14) claims 1-7 | 1-15 |
| A | WO 2020/080256 A1 (DENKA CO., LTD.) 23 April 2020 (2020-04-23) claims 1-5 | 1-15 |
| A | WO 2019/021826 A1 (DOW CORNING TORAY CO., LTD.) 31 January 2019 (2019-01-31) claims 1-16 | 1-15 |
| A | JP 2016-513151 A (DOW CORNING CORP.) 12 May 2016 (2016-05-12) claims 1-20 | 1-15 |
| A | JP 2009-256428 A (SHIN ETSU CHEM. CO., LTD.) 05 November 2009 (2009-11-05) claims 1-4 | 1-15 |
| A | JP 2008-160126 A (SHIN ETSU CHEM. CO., LTD.) 10 July 2008 (2008-07-10) claims 1-5 | 1-15 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **31 July 2023** | **08 August 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

## INTERNATIONAL SEARCH REPORT
**Information on patent family members**

International application No.
**PCT/JP2023/022402**

| Patent document cited in search report | Publication date (day/month/year) | Patent family member(s) | Publication date (day/month/year) |
|---|---|---|---|
| WO 2022/075434 A1 | 14 April 2022 | TW 202227588 A | |
| WO 2020/080256 A1 | 23 April 2020 | US 2021/0407885 A1<br>claims 1-5<br>EP 3868835 A1<br>CN 112805336 A<br>TW 202028312 A | |
| WO 2019/021826 A1 | 31 January 2019 | US 2020/0270499 A1<br>claims 1-13<br>EP 3660100 A1<br>KR 10-2020-0032709 A<br>CN 111051434 A<br>TW 201908413 A | |
| JP 2016-513151 A | 12 May 2016 | WO 2014/124378 A1<br>claims 1-20<br>US 2016/0032060 A1<br>EP 2954024 A1<br>TW 201500469 A<br>CN 104968751 A<br>KR 10-2015-0117268 A | |
| JP 2009-256428 A | 05 November 2009 | (Family: none) | |
| JP 2008-160126 A | 10 July 2008 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 6079792 A